# EUROPEAN PATENT APPLICATION

(11) **EP 4 675 603 A1**
(43) Date of publication of application: **07.01.2026**
(21) Application number: 25186207.4
(22) Date of filing: 30.06.2025
(51) Int. Cl.: G09G 3/3233

(54) **DISPLAY DEVICE AND OPTICAL DEVICE INCLUDING THE SAME**

(30) Priority: 01.07.2024 KR 20240086232
(71) Applicant: Samsung Display Co., Ltd., Yongin-si, Gyeonggi-do 17113 (KR)
(72) Inventor: LEE, Gi Chang, 17113 Yongin-si (KR)
(74) Representative: Taor, Simon Edward William

(57) **Abstract**

A display device includes a first pixel comprising a switching transistor, a driving transistor, a first emission control transistor, and a first light emitting element; a second pixel comprising a second emission control transistor electrically connected to a contact point between the driving transistor and the first emission control transistor and a second light emitting element; and a data driver transmitting a reference voltage, a first data voltage of the first pixel, and a second data voltage of the second pixel to a data line. The first light emitting element emits light during a first sub-frame period of a frame period, the second light emitting element emits light during a second sub-frame period of the frame period, and a gate electrode of the driving transistor is initialized by the reference voltage from the data line during the first sub-frame period.

## Description

### CROSS-REFERENCE TO RELATED APPLICATION

This application claims priority to and benefits of Korean Patent Application No. 10-2024-0086232, filed on July 1, 2024 in the Korean Intellectual Property Office.

### BACKGROUND

### 1. Technical Field

The disclosure relates to a display device capable of securing a large idle area.

### 2. Description of the Related Art

A head mounted display (HMD) is a wearable device that is disposed over a user's head in the form of glasses or a helmet, and provides virtual reality (VR) or augmented reality (AR) to the user's eyes.

The head mounted display uses lenses to magnify and display an image from a small display device. The head mounted display is desirable to provide a high-resolution image, for example, an image having a resolution of 3000 pixels per inch (PPI) or greater. An organic light emitting diode on silicon (OLEDoS), which is a small organic light emitting display device with high resolution, has been used as the display device for the head mounted display. The OLEDoS displays an image and uses organic light emitting diodes (OLEDs) on a semiconductor wafer substrate on which complementary metal oxide semiconductors (CMOSs) are disposed.

It is to be understood that this background of the technology section is, in part, intended to provide useful background for understanding the technology. However, this background of the technology section may also include ideas, concepts, or recognitions that were not part of what was appreciated by those skilled in the pertinent art prior to a corresponding effective filing date of the subject matter disclosed herein.

### SUMMARY

Embodiments provide a display device capable of securing a large idle area.

However, embodiments of the disclosure are not limited to those set forth herein. The above and other embodiments will become more apparent to one of ordinary skill in the art to which the disclosure pertains by referencing the detailed description of the disclosure given below.

According to an aspect of the disclosure, there is provided a display device comprising: a first pixel comprising a switching transistor connected to a data line, a driving transistor connected to the switching transistor, a first emission control transistor connected to the driving transistor, and a first light emitting element connected to the first emission control transistor; a second pixel comprising a second emission control transistor connected to a contact point between the driving transistor and the first emission control transistor and a second light emitting element connected to the second emission control transistor; and a data driver transmitting a reference voltage, a first data voltage of the first pixel, and a second data voltage of the second pixel to the data line. The first light emitting element emits light during a first sub-frame period of a frame period, the second light emitting element emits light during a second sub-frame period of the frame period, and a gate electrode of the driving transistor is initialized by the reference voltage from the data line during the first sub-frame period.

The gate electrode of the driving transistor may be initialized by the reference voltage from the data line during the second sub-frame period.

The first pixel may further comprise an initialization transistor connected between the contact point and a ground or between the contact point and an initialization voltage line.

The first pixel may further comprise a common emission control transistor connected between a driving voltage line and the driving transistor.

The first pixel may further comprise a first capacitor connected between the gate electrode of the driving transistor and a source electrode of the driving transistor, and a second capacitor connected between the source electrode of the driving transistor and the driving voltage line.

The display device may further comprise a write scan line connected to a gate electrode of the switching transistor and transmitting a write scan signal; a common emission control line connected to a gate electrode of the common emission control transistor and transmitting a common emission control signal; a first emission control line connected to a gate electrode of the first emission control transistor and transmitting a first emission control signal; a second emission control line connected to a gate electrode of the second emission control transistor and transmitting a second emission control signal; and a bias scan line connected to a gate electrode of the initialization transistor and transmitting a bias scan signal.

The bias scan signal may have an active level in an initialization period of the first sub-frame period and an initialization period of the second sub-frame period. The write scan signal may have an active level in the initialization period of the first sub-frame period, a data writing period of the first sub-frame period, the initialization period of the second sub-frame period, and a data writing period of the second sub-frame period. The common emission control signal may have an active level in the initialization period of the first sub-frame period, an emission period of the first sub-frame period, the initialization period of the second sub-frame period, and an emission period of the second sub-frame period. The first emission control signal may have an active level in the initialization period of the first sub-frame period and the emission period of the first sub-frame period. The second emission control signal may have an active level in the initialization period of the second sub-frame period and the emission period of the second sub-frame period.

The reference voltage may be applied to the data line in the initialization period of the first sub-frame period, a threshold voltage detection period of the first sub-frame period, the emission period of the first sub-frame period, the initialization period of the second sub-frame period, a threshold voltage detection period of the second sub-frame period, and the emission period of the second sub-frame period. The first data voltage may be applied to the data line in the data writing period of the first sub-frame period, and the second data voltage may be applied to the data line in the data writing period of the second sub-frame period.

The first pixel may further comprise a compensation transistor connected between the gate electrode of the driving transistor and the contact point.

The first pixel may further comprise a first capacitor connected between the switching transistor and the gate electrode of the driving transistor; and a second capacitor connected between the gate electrode of the driving transistor and a driving voltage line.

The driving transistor may be connected between the driving voltage line and the contact point.

The display device may further comprise a write scan line connected to a gate electrode of a switching transistor and transmitting a write scan signal; a compensation scan line connected to a gate electrode of a compensation transistor and transmitting a compensation scan signal; a first emission control line connected to a gate electrode of a first emission control transistor and transmitting a first emission control signal; a second emission control line connected to a gate electrode of the second emission control transistor and transmitting a second emission control signal; and a bias scan line connected to a gate electrode of the initialization transistor and transmitting a bias scan signal.

The bias scan signal may have an active level in an initialization period of the first sub-frame period. The write scan signal may have an active level in the initialization period of the first sub-frame period, a data writing period of the first sub-frame period, and a data writing period of the second sub-frame period. The compensation scan signal may have an active level in the initialization period of the first sub-frame period and a threshold voltage detection period of the first sub-frame period. The first emission control signal may have an active level in the initialization period of the first sub-frame period and an emission period of the first sub-frame period. The second emission control signal may have an active level in the initialization period of the first sub-frame period and an emission period of the second sub-frame period.

The bias scan signal may have an active level in an initialization period of the first sub-frame period. The write scan signal may have an active level in the initialization period of the first sub-frame period, a data writing period of the first sub-frame period, a reset period of the second sub-frame period, and a data writing period of the second sub-frame period. The compensation scan signal may have an active level in the initialization period of the first sub-frame period and a threshold voltage detection period of the first sub-frame period. The first emission control signal may have an active level in the initialization period of the first sub-frame period and an emission period of the first sub-frame period. The second emission control signal may have an active level in the initialization period of the first sub-frame period and an emission period of the second sub-frame period.

The display device may further comprise a third pixel comprising a third emission control transistor connected to the contact point and a third light emitting element connected to the third emission control transistor.

The data driver may further apply a third data voltage of the third pixel to the data line, the third light emitting element may emit light in a third sub-frame period of the frame period, and a gate electrode of the driving transistor may be initialized by a reference voltage from the data line in the third sub-frame period.

The display device may further comprise a fourth pixel comprising a fourth emission control transistor connected to the contact point and a fourth light emitting element connected to the fourth emission control transistor.

The data driver may further apply a fourth data voltage of the fourth pixel to the data line, the fourth light emitting element may emit light in a fourth sub-frame period of the frame period, and a gate electrode of the driving transistor may be initialized by a reference voltage from the data line in the fourth sub-frame period.

The display device may further comprise a fifth pixel comprising a fifth emission control transistor connected to the contact point and a fifth light emitting element connected to the fifth emission control transistor.

The data driver may further apply a fifth data voltage of the fifth pixel to the data line, the fifth light emitting element may emit light in a fifth sub-frame period of the frame period, and a gate electrode of the driving transistor may be initialized by a reference voltage from the data line in the fifth sub-frame period.

The display device may further comprise a driving circuit overlapping the second pixel in a plan view.

The driving circuit may comprise at least one of a power supply circuit providing a driving voltage to the driving transistor; a scan driver providing a scan signal to a gate electrode of the switching transistor; an emission driver providing an emission control signal to each of a gate electrode of the first emission control transistor and a gate electrode of the second emission control transistor; and the data driver.

According to an aspect of the disclosure, there is provided an optical device comprising: a display device; and an optical path conversion member on the display device, wherein the display device comprises a first pixel comprising a switching transistor connected to a data line, a driving transistor connected to the switching transistor, a first emission control transistor connected to the driving transistor, and a first light emitting element connected to the first emission control transistor; a second pixel comprising a second emission control transistor connected to a contact point between the driving transistor and the first emission control transistor and a second light emitting element connected to the second emission control transistor; and a data driver transmitting a reference voltage, a first data voltage of the first pixel, and a second data voltage of the second pixel to the data line. The first light emitting element emits light during a first sub-frame period of a frame period, the second light emitting element emits light during a second sub-frame period of the frame period, and a gate electrode of the driving transistor is initialized by the reference voltage from the data line during the first sub-frame period.

The gate electrode of the driving transistor may be initialized by the reference voltage from the data line during the second sub-frame period.

The first pixel may further include an initialization transistor connected between the contact point and a ground or between the contact point and an initialization voltage line.

The first pixel may further include a common emission control transistor connected between a driving voltage line and the driving transistor.

The first pixel may further include a compensation transistor connected between the gate electrode of the driving transistor and the contact point.

The first pixel may further include: a first capacitor connected between the switching transistor and the gate electrode of the driving transistor; and a second capacitor connected between the gate electrode of the driving transistor and a driving voltage line.

The optical device may be at least one of a smart watch, a mobile phone, a smartphone, a portable computer, a tablet personal computer (PC), a watch phone, an automotive display, a smart glass, a portable multimedia player (PMP), a navigation system, an ultra mobile computer (UMPC), a head mounted display (HMD) device, a virtual reality (VR) device, a mixed reality (MR) device, and an augmented reality (AR) device.

In accordance with a display device of an embodiment, a large idle area may be secured. In this idle area, a driving part of the display device may be disposed. Accordingly, the display device according to an embodiment may be manufactured with high integration.

According to an aspect, there is provided a display device as set out in claim 1. Additional features are set out in claims 2 to 12. According to an aspect, there is provided an optical device set out in claim 13. Additional features are set out in claim 14. According to an aspect, there is provided an electronic device set out in claim 15.

The effects of the disclosure are not limited to the above-described effects and other effects which are not described herein will become apparent to those skilled in the art from the following description.

### BRIEF DESCRIPTION OF THE DRAWINGS

An additional appreciation according to the embodiments of the disclosure will become more apparent by describing in detail the embodiments thereof with reference to the accompanying drawings, wherein:
FIG. 1 is a schematic exploded perspective view illustrating a display device according to an embodiment;
FIG. 2 is a schematic block diagram illustrating the display device according to an embodiment;
FIG. 3 is a schematic diagram of an equivalent circuit illustrating a first pixel according to an embodiment;
FIG. 4 is a schematic layout diagram illustrating an example of a display panel according to an embodiment;
FIGS. 5 and 6 are schematic layout diagrams illustrating embodiments of a display area of FIG. 4;
FIG. 7 is a schematic cross-sectional view illustrating an example of the display panel taken along line I1-I1' of FIG. 5;
FIG. 8 is a schematic diagram of an equivalent circuit illustrating a first pixel according to an embodiment;
FIG. 9 is a schematic diagram of an equivalent circuit illustrating second, third, fourth, and fifth pixels electrically connected to the first pixel of FIG. 8;
FIG. 10 is a schematic diagram illustrating an embodiment in respect to a timing diagram of a reference voltage, data voltages, a bias scan signal, a write scan signal, a common emission control signal, a first emission control signal, a second emission control signal, a third emission control signal, a fourth emission control signal, and a fifth emission control signal of FIG. 9;
FIG. 11 is a schematic diagram of an equivalent circuit illustrating a first pixel according to an embodiment;
FIG. 12 is a schematic diagram of an equivalent circuit illustrating second, third, fourth, and fifth pixels electrically connected to the first pixel of FIG. 11;
FIG. 13 is a schematic diagram illustrating an embodiment in respect to a timing diagram of a reference voltage, data voltages, a bias scan signal, a write scan signal, a compensation scan signal, a first emission control signal, a second emission control signal, a third emission control signal, a fourth emission control signal, and a fifth emission control signal of FIG. 11;
FIG. 14 is a schematic diagram illustrating an embodiment in respect to a timing diagram of a reference voltage, data voltages, a bias scan signal, a write scan signal, a compensation scan signal, a first emission control signal, a second emission control signal, a third emission control signal, a fourth emission control signal, and a fifth emission control signal of FIG. 12;
FIG. 15 is a schematic plan view of a display device according to an embodiment;
FIG. 16 is a schematic perspective view illustrating a head mounted display device according to an embodiment;
FIG. 17 is a schematic exploded perspective view illustrating an example of the head mounted display device of FIG. 16; and
FIG. 18 is a schematic perspective view illustrating a head mounted display device according to an embodiment.
FIG. 19 is a block diagram of an electronic device according to one embodiment.
FIGS. 20, 21 and 22 are schematic diagrams of electronic devices according to various embodiments.

### DETAILED DESCRIPTION OF THE EMBODIMENTS

In the following description, for the purposes of explanation, numerous specific details are set forth in order to provide a thorough understanding of various embodiments or implementations of the disclosure. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the disclosure. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the scope of the disclosure.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the axis of the first direction DR1, the axis of the second direction DR2, and the axis of the third direction DR3 are not limited to three axes of a rectangular coordinate system, such as the X, Y, and Z-axes, and may be interpreted in a broader sense. For example, the axis of the first direction DR1, the axis of the second direction DR2, and the axis of the third direction DR3 may be perpendicular to one another, or may represent different directions that are not perpendicular to one another. For the purposes of this disclosure, "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein should be interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the disclosure. Further, the blocks, units, and/or modules of some embodiments may be physically combined into more complex blocks, units, and/or modules without departing from the scope of the disclosure.

The terms "about" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

Hereinafter, embodiments are described in detail with reference to the accompanying drawings.

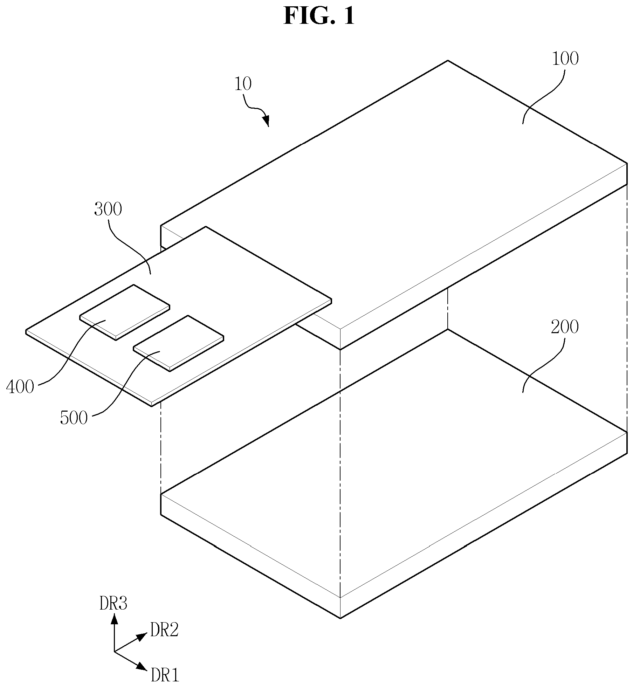

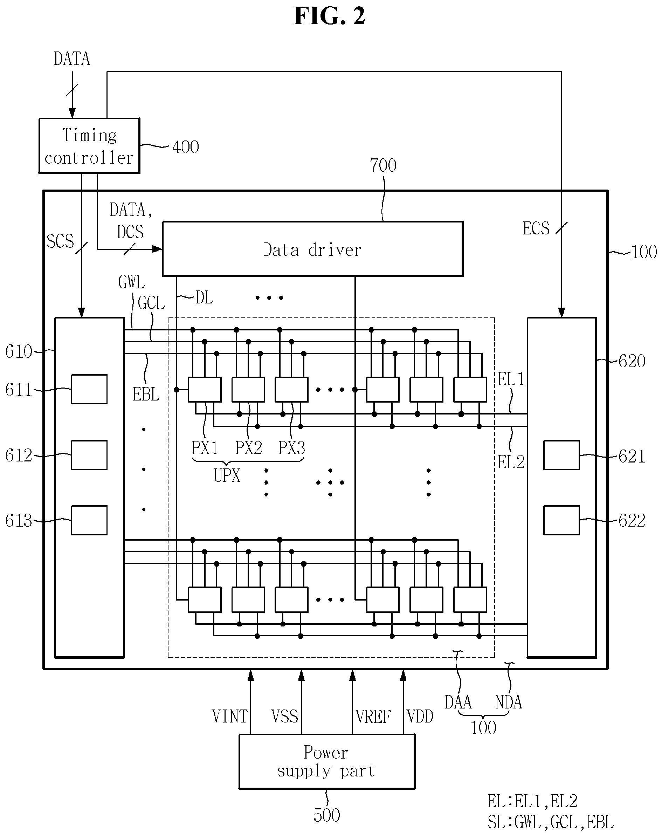

FIG. 1 is a schematic exploded perspective view illustrating a display device according to an embodiment. FIG. 2 is a schematic block diagram illustrating the display device according to an embodiment.

Referring to FIGS. 1 and 2, a display device 10 according to an embodiment may display a moving image or a still image. The display device 10 according to an embodiment may be applied to portable electronic devices such as mobile phones, smartphones, tablet personal computers (PCs), mobile communication terminals, electronic notebooks, electronic books, portable multimedia players (PMPs), navigation devices, and ultra mobile PCs (UMPCs). For example, the display device 10 according an embodiment may be applied as a display part of televisions, laptop computers, monitors, billboards, the Internet of Things (IOTs), or the like. In other embodiments, the display device 10 according an embodiment may be applied to smart watches, watch phones, or head mounted displays (HMDs) for implementing virtual reality and augmented reality.

The display device 10 according to an embodiment may include a display panel 100, a heat dissipation layer 200, a circuit board 300, a timing control circuit 400, and a power supply circuit 500.

The display panel 100 may have a shape similar to a rectangular shape in a plan view. For example, the display panel 100 may have a shape similar to a rectangular shape, in a plan view, having short sides in a first direction DR1 and long sides in a second direction DR2 intersecting (or crossing) the first direction DR1. In the display panel 100, a corner where the short side in the first direction DR1 and the long side in the second direction DR2 meet may be rounded with a curvature (e.g., a predetermined or selectable curvature) or right-angled. The shape of the display panel 100 in a plan view is not limited to the rectangular shape, and may be a shape similar to other polygonal shapes, a circular shape, or an elliptical shape. A shape of the display device 10 in a plan view may follow the shape of the display panel 100 in a plan view, but embodiments of the disclosure are not limited thereto.

The display panel 100 may include a display area DAA that displays an image and a non-display area NDA that does not display an image, as illustrated in FIG. 2.

The display area DAA may include pixels PX1, PX2, and PX3, scan lines SL, emission control lines EL, and data lines DL.

The pixels PX1, PX2, and PX3 may be disposed (e.g., arranged) in a matrix form in the first direction DR1 and the second direction DR2. The scan lines SL and the emission control lines EL may extend in the first direction DR1 and may be disposed (or arranged) in the second direction DR2. The data lines DL may extend in the second direction DR2 and may be disposed in the first direction DR1.

The scan lines SL include write scan lines GWL, compensation scan lines GCL, and bias scan lines EBL. The emission control lines EL include first emission control lines EL1 and second emission control lines EL2.

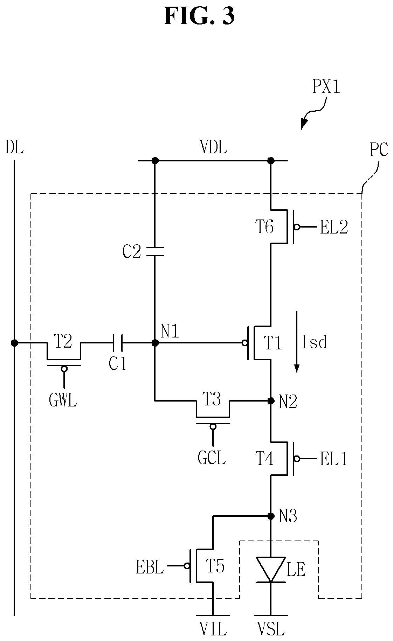

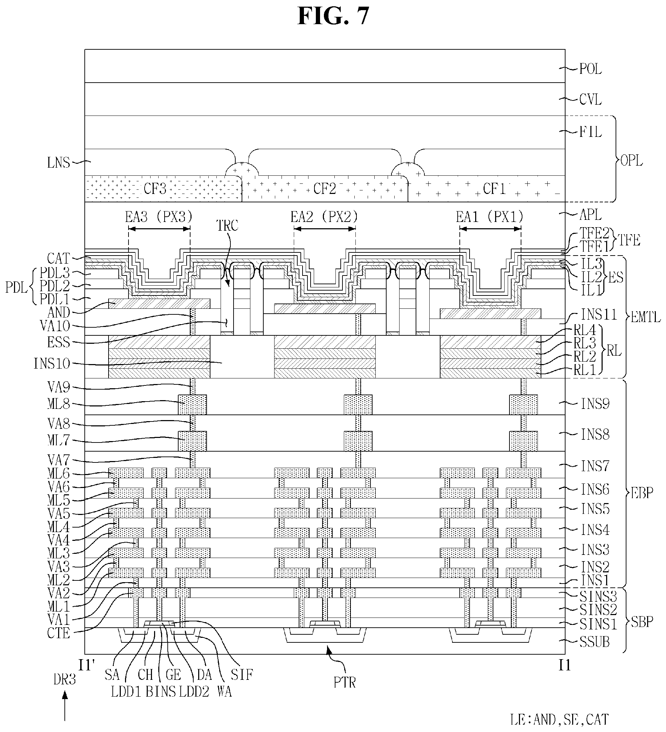

Each of unit pixels (or pixel groups) UPX may include pixels PX1, PX2, and PX3. The pixels PX1, PX2, and PX3 may include pixel transistors as illustrated in FIG. 3. The pixel transistors of the pixels PX1, PX2, and PX3 may be formed by a semiconductor process and be disposed on a semiconductor substrate SSUB (e.g., refer to FIG. 7). For example, pixel transistors of a data driver 700 may include (or be formed as) complementary metal oxide semiconductors (CMOSs).

Each of the pixels PX1, PX2, and PX3 may be electrically connected to any one of the write scan lines GWL, any one of the compensation scan lines GCL, any one of the bias scan lines EBL, any one of the first emission control lines EL1, any one of the second emission control lines EL2, and any one of the data lines DL. Each of the pixels PX1, PX2, and PX3 may receive a data voltage of the data line DL according to a write scan signal of the write scan line GWL, and a light emitting element may emit light according to the data voltage.

The non-display area NDA may include a scan driver 610, an emission driver 620, and a data driver 700. For example, the scan driver 610, the emission driver 620, and the data driver 700 may be disposed in the non-display area NDA.

The scan driver 610 may include scan transistors, and the emission driver 620 may include light emitting transistors. The scan transistors and the light emitting transistors may be formed by a semiconductor process and be disposed (or formed) on a semiconductor substrate SSUB (e.g., refer to FIG. 7). For example, the scan transistors and the light emitting transistors may include (or be formed as) CMOSs. In FIG. 2, the scan driver 610 may be disposed on the left side of the display area DAA, and the emission driver 620 may be disposed on the right side of the display area DAA. However, embodiments of the disclosure are not limited thereto. For example, the scan drivers 610 and the emission drivers 620 may be disposed on any one of the left and right sides of the display area DAA.

The scan driver 610 may include a write scan signal output part 611, a compensation scan signal output part 612, and a bias scan signal output part 613. Each of the write scan signal output part 611, the compensation scan signal output part 612, and the bias scan signal output part 613 may receive a scan timing control signal SCS from the timing control circuit 400. The write scan signal output part 611 may generate write scan signals according to the scan timing control signal SCS of the timing control circuit 400 and sequentially output the write scan signals to the write scan lines GWL. The compensation scan signal output part 612 may generate compensation scan signals according to the scan timing control signal SCS and sequentially output the compensation scan signals to the compensation scan lines GCL. The bias scan signal output part 613 may generate bias scan signals according to the scan timing control signal SCS and sequentially output the bias scan signals to the bias scan lines EBL.

The emission driver 620 may include a first emission control driver 621 and a second emission control driver 622. Each of the first emission control driver 621 and the second emission control driver 622 may receive an emission timing control signal ECS from the timing control circuit 400. The first emission control driver 621 may generate first emission control signals according to the emission timing control signal ECS and sequentially output the first emission control signals to the first emission control lines EL1. The second emission control driver 622 may generate second emission control signals according to the emission timing control signal ECS and sequentially output the second emission control signals to the second emission control lines EL2.

The data driver 700 may include data transistors. The data transistors of the data driver 700 may be formed by a semiconductor process and be disposed (or formed) on a semiconductor substrate SSUB (e.g., refer to FIG. 7). For example, the data transistors may include (or be formed as) CMOSs.

The data driver 700 may receive digital video data DATA and a data timing control signal DCS from the timing control circuit 400. The data driver 700 may convert the digital video data DATA into analog data voltages according to the data timing control signal DCS and output the analog data voltages to the data lines DL. The pixels PX1, PX2, and PX3 may be selected by the write scan signals of the scan driver 610, and the data voltages may be supplied to the selected pixels PX1, PX2, and PX3.

The heat dissipation layer 200 may overlap the display panel 100 in a third direction DR3, which is a thickness direction of the display panel 100. The heat dissipation layer 200 may be disposed on a surface, for example, a rear surface (or a lower surface), of the display panel 100. The heat dissipation layer 200 may dissipate heat generated from the display panel 100. The heat dissipation layer 200 may include a metal layer including at least one of graphite, silver (Ag), copper (Cu), and aluminum (Al) having high thermal conductivity. However, embodiments of the disclosure are not limited thereto.

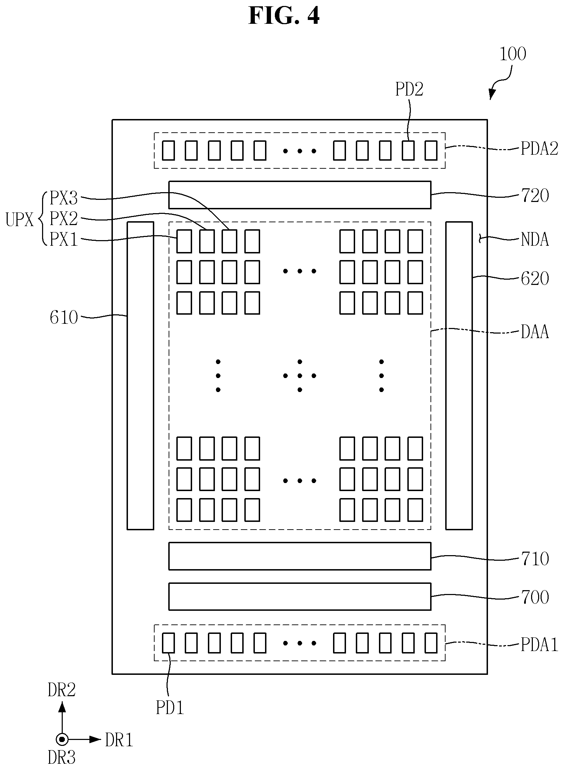

The circuit board 300 may be electrically connected to first pads PD1 (e.g., refer to FIG. 4) of a first pad part PDA1 (e.g., refer to FIG. 4) of the display panel 100 using a conductive adhesive member such as an anisotropic conductive film. The circuit board 300 may be (or include) a flexible printed circuit board or a flexible film having a flexible material. In FIG. 1, the circuit board 300 may be unbent (or rigid), but the circuit board 300 may be bent. An end of the circuit board 300 may be disposed on the rear surface (or the lower surface) of the display panel 100 and/or a rear surface (or a lower surface) of the heat dissipation layer 200. The end of the circuit board 300 may be an end opposite to another end of the circuit board 300 electrically connected to the first pads PD1 (e.g., refer to FIG. 4) of the first pad part PDA1 (e.g., refer to FIG. 4) of the display panel 100 using the conductive adhesive member.

The timing control circuit 400 may receive digital video data DATA and timing signals from the outside. The timing control circuit 400 may generate the scan timing control signal SCS, the emission timing control signal ECS, and the data timing control signal DCS for controlling the display panel 100 according to the timing signals. The timing control circuit 400 may output the scan timing control signal SCS to the scan driver 610 and output the emission timing control signal ECS to the emission driver 620. The timing control circuit 400 may output the digital video data DATA and the data timing control signal DCS to the data driver 700.

The power supply circuit 500 may generate panel driving voltages according to an external source voltage. For example, the power supply circuit 500 may generate a first driving voltage VSS, a second driving voltage VDD, and a third driving voltage VINT, and supply the first driving voltage VSS, the second driving voltage VDD, and the third driving voltage VINT to the display panel 100. Detailed description of the first driving voltage VSS, the second driving voltage VDD, and the third driving voltage VINT is provided below with reference to FIG. 3.

Each of the timing control circuit 400 and the power supply circuit 500 may include (or be formed as) an integrated circuit (IC) and attached to a surface of the circuit board 300. The scan timing control signal SCS, the emission timing control signal ECS, the digital video data DATA, and the data timing control signal DCS of the timing control circuit 400 may be supplied to the display panel 100 through the circuit board 300. The first driving voltage VSS, the second driving voltage VDD, and the third driving voltage VINT of the power supply circuit 500 may be supplied to the display panel 100 through the circuit board 300.

In other embodiments, each of the timing control circuit 400 and the power supply circuit 500 may be disposed in the non-display area NDA of the display panel 100. For example, the scan driver 610, the emission driver 620, and the data driver 700 may also be disposed in the non-display area NDA of the display panel 100. The timing control circuit 400 may include timing transistors, and the power supply circuit 500 may include power transistors. The timing transistors and the power transistors may be formed by a semiconductor process and be disposed (or formed) on a semiconductor substrate SSUB (e.g., refer to FIG. 7). For example, the timing transistors and the power transistors may include (or be formed as) CMOSs. Each of the timing control circuit 400 and the power supply circuit 500 may be disposed between the data driver 700 and the first pad part PDA1 (e.g., refer to FIG. 4).

FIG. 3 is a schematic diagram of an equivalent circuit illustrating a first pixel according to an embodiment.

Referring to FIG. 3, a first pixel PX1 may be electrically connected to a write scan line GWL, a compensation scan line GCL, a bias scan line EBL, a first emission control line EL1, a second emission control line EL2, and a data line DL. The first pixel PX1 may be electrically connected to a first driving voltage line VSL to which a first driving voltage VSS (e.g., refer to FIG. 2) corresponding to a low potential voltage is applied, a second driving voltage line VDL to which a second driving voltage VDD (e.g., refer to FIG. 2) corresponding to a high potential voltage is applied, and a third driving voltage line VIL to which a third driving voltage VINT (e.g., refer to FIG. 2) corresponding to an initialization voltage is applied. For example, the first driving voltage line VSL may be a low potential voltage line, the second driving voltage line VDL may be a high potential voltage line, and the third driving voltage line VIL may be an initialization voltage line. The first driving voltage VSS may be a voltage lower than the third driving voltage VINT. The second driving voltage VDD may be a voltage higher than the third driving voltage VINT.

The first pixel PX1 may include a pixel circuit PC and a light emitting element LE electrically connected to the pixel circuit PC.

The pixel circuit PC may include a first transistor T1, a second transistor T2, a third transistor T3, a fourth transistor T4, a fifth transistor T5, a sixth transistor T6, a first capacitor C1, and a second capacitor C2.

The light emitting element LE may emit light according to a driving current Isd flowing through a channel of a first transistor T1. An amount of light emitted from the light emitting element LE may be proportional to the driving current Isd. The light emitting element LE may be disposed between a fourth transistor T4 and the first driving voltage line VSL. A first electrode of the light emitting element LE may be electrically connected to a drain electrode of the fourth transistor T4, and a second electrode of the light emitting element LE may be electrically connected to the first driving voltage line VSL. The first electrode of the light emitting element LE may be an anode electrode, and the second electrode of the light emitting element LE may be a cathode electrode. The light emitting element LE may be an organic light emitting diode including a first electrode, a second electrode, and an organic light emitting layer disposed between the first electrode and the second electrode, but embodiments of the disclosure are not limited thereto. For example, the light emitting element LE may be an inorganic light emitting element including a first electrode, a second electrode, and an inorganic semiconductor disposed between the first electrode and the second electrode. For example, the light emitting element LE may be a micro light emitting diode.

The first transistor T1 may be a driving transistor controlling the source-drain current Isd (hereinafter referred to as a "driving current") flowing between a source electrode and a drain electrode according to a voltage applied to a gate electrode of the first transistor T1. The first transistor T1 may include the gate electrode electrically connected to a first node N1, the source electrode electrically connected to a drain electrode of a sixth transistor T6, and the drain electrode electrically connected to a second node N2.

The second transistor T2 may be disposed between an electrode of the first capacitor C1 and the data line DL. The second transistor T2 may be turned on by a write scan signal of the write scan line GWL and electrically connect the electrode of the first capacitor C1 to the data line DL. Thus, a data voltage of the data line DL may be applied to the electrode of the first capacitor C1. The second transistor ST2 may include a gate electrode electrically connected to the write scan line GWL, a source electrode electrically connected to the data line DL, and a drain electrode electrically connected to the electrode of the first capacitor C1.

The third transistor T3 may be disposed between the first node N1 and the second node N2. The third transistor T3 may be turned on by a compensation scan signal of the compensation scan line GCL and electrically connect the first node N1 to the second node N2. Thus, the gate electrode and the drain electrode of the first transistor T1 may be electrically connected to each other, and the first transistor T1 may operate like a diode. The third transistor T3 may include a gate electrode electrically connected to the compensation scan line GCL, a source electrode electrically connected to the second node N2, and a drain electrode electrically connected to the first node N1.

The fourth transistor T4 may be electrically connected between the second node N2 and a third node N3. The fourth transistor T4 may be turned on by a first emission control signal of the first emission control line EL1 and electrically connect the second node N2 to the third node N3. Thus, the driving current of the first transistor T1 may be supplied to the light emitting element LE. The fourth transistor T4 may include a gate electrode electrically connected to the first emission control line EL1, a source electrode electrically connected to the second node N2, and the drain electrode electrically connected to the third node N3.

The fifth transistor T5 may be disposed between the third node N3 and the third driving voltage line VIL. The fifth transistor T5 may be turned on by a bias scan signal of the bias scan line EBL and electrically connect the third node N3 to the third driving voltage line VIL. Thus, the third driving voltage VINT of the third driving voltage line VIL may be applied to the first electrode of the light emitting element LE. The fifth transistor T5 may include a gate electrode electrically connected to the bias scan line EBL, a source electrode electrically connected to the third node N3, and a drain electrode electrically connected to the third driving voltage line VIL.

The sixth transistor T6 may be disposed between the source electrode of the first transistor T1 and the second driving voltage line VDL. The sixth transistor T6 may be turned on by a second emission control signal of the second emission control line EL2 and electrically connect the source electrode of the first transistor T1 to the second driving voltage line VDL. Thus, the second driving voltage VDD of the second driving voltage line VDL may be applied to the source electrode of the first transistor T1. The sixth transistor T6 may include a gate electrode electrically connected to the second emission control line EL2, a source electrode electrically connected to the second driving voltage line VDL, and the drain electrode electrically connected to the source electrode of the first transistor T1.

The first capacitor C1 may be formed between the first node N1 and the drain electrode of the second transistor T2. The first capacitor C1 may include an electrode electrically connected to the drain electrode of the second transistor T2 and another electrode electrically connected to the first node N1.

The second capacitor C2 may be formed between the gate electrode of the first transistor T1 and the second driving voltage line VDL. The second capacitor C2 may include an electrode electrically connected to the gate electrode of the first transistor T1 and the another electrode electrically connected to the second driving voltage line VDL.

The first node N1 may be a contact point between the gate electrode of the first transistor T1, the drain electrode of the third transistor T3, the another electrode of the first capacitor C1, and the electrode of the second capacitor C2. The second node N2 may be a contact point between the drain electrode of the first transistor T1, the source electrode of the third transistor T3, and the source electrode of the fourth transistor T4. The third node N3 may be a contact point between the drain electrode of the fourth transistor T4, the source electrode of the fifth transistor T5, and the first electrode of the light emitting element LE.

Each of the first to sixth transistors T1 to T6 may be a metal oxide semiconductor field effect transistor (MOSFET). For example, each of the first to sixth transistors T1 to T6 may be a P-type MOSFET, but embodiments of the disclosure are not limited thereto. Each of the first to sixth transistors T1 to T6 may be an N-type MOSFET. In other embodiments, some of the first to sixth transistors T1 to T6 may be P-type MOSFETs, and others of the first to sixth transistors T1 to T6 may be N-type MOSFETs.

In FIG. 3, the first pixel PX1 may include the six transistors T1 to T6 and two capacitors C1 and C2. However, a schematic diagram of an equivalent circuit illustrating the first pixel PX1 is not limited to that illustrated in FIG. 3. For example, the numbers of transistors and capacitors of the first pixel PX1 are not limited to those illustrated in FIG. 3.

A schematic diagram of an equivalent circuit of a second pixel PX2 and a schematic diagram of an equivalent circuit of a third pixel PX3 may be substantially the same as or similar to the schematic diagram of the equivalent circuit of the first pixel PX1 described with reference to FIG. 3. Therefore, detailed description of the schematic diagram of the equivalent circuit of the second pixel PX2 and the schematic diagram of the equivalent circuit of the third pixel PX3 is omitted in the disclosure.

FIG. 4 is a schematic layout diagram illustrating an example of a display panel according to an embodiment.

Referring to FIG. 4, the display area DAA of the display panel 100 according to an embodiment may include pixels PX1, PX2, and PX3 disposed (or arranged) in a matrix form. The non-display area NDA of the display panel 100 according to an embodiment may include a scan driver 610, an emission driver 620, a data driver 700, a first distribution circuit 710, a second distribution circuit 720, a first pad part PDA1, and a second pad part PDA2.

The scan driver 610 may be disposed on a first side of the display area DAA, and the emission driver 620 may be disposed on a second side of the display area DAA. For example, the scan driver 610 may be disposed on a side of the display area DAA in the first direction DR1, and the emission driver 620 may be disposed on another side of the display area DAA in the first direction DR1. For example, the scan driver 610 may be disposed on the left side of the display area DAA, and the emission driver 620 may be disposed on the right side of the display area DAA. However, embodiments of the disclosure are not limited thereto, and the scan drivers 610 and the emission drivers 620 may be disposed on any one of the first and second sides of the display area DAA.

The first pad part PDA1 may include first pads PD1 electrically connected to pads or bumps of the circuit board 300 through a conductive adhesive member. The first pad part PDA1 may be disposed on a third side of the display area DAA. For example, the first pad part PDA1 may be disposed on a side of the display area DAA in the second direction DR2.

The first pad part PDA1 may be disposed outside the data driver 700 in the second direction DR2. For example, the first pad part PDA1 may be disposed closer to an edge of the display panel 100 than the data driver 700.

The second pad part PDA2 may include second pads PD2 corresponding to inspection pads that inspect whether or not the display panel 100 operates normally. The second pads PD2 may be electrically connected to a jig or a probe pin. In other embodiments, the second pads PD1 may be electrically connected to a circuit board for inspection in an inspection process. The circuit board for inspection may be a printed circuit board including a rigid material or a flexible printed circuit board including a flexible material.

The first distribution circuit 710 may distribute data voltages applied through the first pad part PDA1 to data lines DL. For example, the first distribution circuit 710 may distribute data voltages applied through a first pad PD1 of the first pad part PDA1 to P data lines DL (P is a positive integer of 2 or greater), and the number of first pads PD1 may be reduced. The first distribution circuit 710 may be disposed on the third side of the display area DAA of the display panel 100. For example, the first distribution circuit 710 may be disposed on a side of the display area DAA in the second direction DR2. For example, the first distribution circuit 710 may be disposed on the lower side of the display area DAA.

The second distribution circuit 720 may distribute signals applied through the second pad part PDA2 to the scan driver 610, the emission driver 620, and the data lines DL. The second pad part PDA2 and the second distribution circuit 720 may inspect an operation of each of the pixels PX1, PX2, and PX3 of the display area DAA. The second distribution circuit 720 may be disposed on a fourth side of the display area DAA of the display panel 100. For example, the second distribution circuit 720 may be disposed on the another side of the display area DAA in the second direction DR2. For example, the second distribution circuit 720 may be disposed on the upper side of the display area DAA.

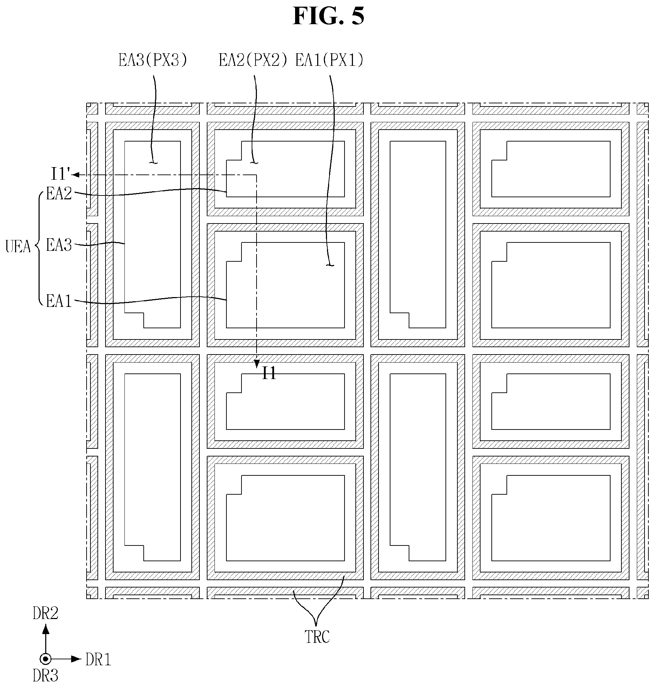

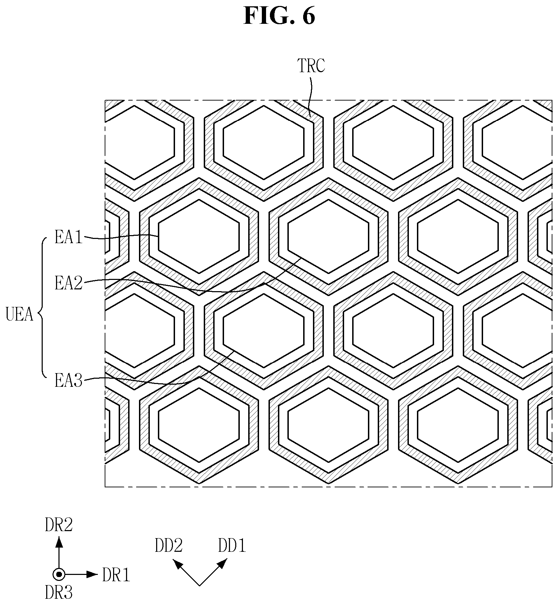

FIGS. 5 and 6 are schematic layout diagrams illustrating embodiments of a display area of FIG. 4.

Referring to FIGS. 5 and 6, each of the unit pixels UPX (e.g., refer to FIG. 4) may include a first emission area EA1 that is an emission area of the first pixel PX1, a second emission area EA2 that is an emission area of the second pixel PX2, and a third emission area EA3 that is an emission area of the third pixel PX3. For example, the unit pixel UPX may include a unit emission area (or an emission area group) UEA, and this unit emission area UEA may include the first emission area EA1, the second emission area EA2, and the third emission area EA3.

Referring to FIGS. 5 and 6, each of the pixels PX1, PX2, and PX3 may include each of the first emission area EA1 that is the emission area of the first pixel PX1, the second emission area EA2 that is the emission area of the second pixel PX2, and the third emission area EA3 that is the emission area of the third pixel PX3.

Each of the first emission area EA1, the second emission area EA2, and the third emission area EA3 may have a polygonal shape, a circular shape, an elliptical shape, an irregular shape, or the like in a plan view.

A maximum length of the third emission area EA3 in the first direction DR1 may be smaller than a maximum length of the first emission area EA1 in the first direction DR1 and a maximum length of the second emission area EA2 in the first direction DR1. For example, the maximum length of the third emission area EA3 in the first direction DR1 may be smaller than the maximum length of the first emission area EA1 (or the maximum length of the second emission area EA2) in the first direction DR1. The maximum length of the first emission area EA1 in the first direction DR1 and the maximum length of the second emission area EA2 in the first direction DR1 may be substantially the same as or similar to each other.

A maximum length of the third emission area EA3 in the second direction DR2 may be greater than a maximum length of the first emission area EA1 in the second direction DR2 and a maximum length of the second emission area EA2 in the second direction DR2. The maximum length of the first emission area EA1 in the second direction DR2 may be greater than the maximum length of the second emission area EA2 in the second direction DR2. The maximum length of the first emission area EA1 in the second direction DR2 may be smaller than the maximum length of the third emission area EA3 in the second direction DR2.

Each of the first emission area EA1, the second emission area EA2, and the third emission area EA3 may have a hexagonal shape including six straight lines, in a plan view, as illustrated in FIGS. 5 and 6, but embodiments of the disclosure are not limited thereto. For example, each of the first to third emission areas EA1, EA2, and EA3 may have substantially quadrangular shape having a recessed portion (e.g., refer to FIG. 5), a honeycomb shape (e.g., refer to FIG. 6), or the like. Each of the first emission area EA1, the second emission area EA2, and the third emission area EA3 may have polygonal shapes other than the hexagonal shape, a circular shape, an elliptical shape, or an irregular shape in a plan view.

As illustrated in FIG. 5, in each of the unit pixels UPX, the first emission area EA1 and the second emission area EA2 may be adjacent to (or neighbor to) each other in the second direction DR2. The first emission area EA1 and the third emission area EA3 may be adjacent to (or neighbor to) each other in the first direction DR1. The second emission area EA2 and the third emission area EA3 may be adjacent to (or neighbor to) each other in the first direction DR1. An area of the first emission area EA1, an area of the second emission area EA2, and an area of the third emission area EA3 may be different from each other.

In other embodiments, as illustrated in FIG. 6, the first emission area EA1 and the second emission area EA2 may be adjacent to (or neighbor to) each other in the first direction DR1. The second emission area EA2 and the third emission area EA3 may be adjacent to (or neighbor to) each other in a first diagonal direction DD1. The first emission area EA1 and the third emission area EA3 may be adjacent to (or neighbor to) each other in a second diagonal direction DD2. The first diagonal direction DD1 may be a direction between the first direction DR1 and the second direction DR2 and may refer to a direction inclined at an angle between the first direction DR1 and the second direction DR2 (e.g., a direction inclined by about 45° with respect to the first direction DR1 and the second direction DR2), and the second diagonal direction DD2 may be a direction intersecting (e.g., orthogonal to) the first diagonal direction DD1.

The first emission area EA1 may emit light of a first color, the second emission area EA2 may emit light of a second color, and the third emission area EA3 may emit light of a third color. The light of the first color may be light of a blue wavelength band, the light of the second color may be light of a green wavelength band, and the light of the third color may be light of a red wavelength band. For example, the light of the blue wavelength band may have a wavelength band (e.g., a main peak wavelength of the light) in a range of about 370 nm to about 460 nm, the light of the green wavelength band may have a wavelength band (e.g., a main peak wavelength of the light) in a range of about 480 nm to about 560 nm, and the light of the red wavelength band may have a wavelength band (e.g., a main peak wavelength of the light) in a range of about 600 nm to about 750 nm.

In FIGS. 5 and 6, each of the unit pixels UPX may include three emission areas EA1, EA2, and EA3. However, embodiments of the disclosure are not limited thereto. For example, each of the unit pixels UPX may also include four (or more) emission areas.

An arrangement of the emission areas of the unit pixels UPX is not limited to those illustrated in FIGS. 5 and 6. For example, the emission areas of the unit pixels UPX may be disposed in a stripe structure in which the emission areas are disposed (e.g., arranged) in the first direction DR1, a PenTile^{®} structure in which the emission areas have a diamond arrangement, or a hexagonal structure in which emission areas having a hexagonal shape in a plan view are disposed (e.g., arranged) as illustrated in FIG. 6.

FIG. 7 is a schematic cross-sectional view illustrating an example of the display panel taken along line I1-I1' of FIG. 5.

Referring to FIG. 7, the display panel 100 (e.g., refer to FIG. 4) may include a semiconductor backplane SBP, a light emitting element backplane EBP, a display element layer EMTL, an encapsulation layer TFE, an optical layer OPL, a cover layer CVL, and a polarizing plate POL.

The semiconductor backplane SBP may include a semiconductor substrate SSUB including pixel transistors PTR, semiconductor insulating films SINS1, SINS2, and SINS3 covering the pixel transistors PTR, and contact terminals CTE electrically connected to the pixel transistors PTR, respectively. The pixel transistors PTR may be the first to sixth transistors T1 to T6 described with reference to FIG. 3.

The semiconductor substrate SSUB may be a silicon substrate, a germanium substrate, a silicon-germanium substrate, or the like. The semiconductor substrate SSUB may be a substrate doped with first-type impurities. Well regions WA may be disposed in an upper surface of the semiconductor substrate SSUB. The well regions WA may be regions doped with second-type impurities. The second-type impurities may be different from the first-type impurities described above. For example, in case that the first-type impurities are p-type impurities, the second-type impurities may be n-type impurities. In other embodiments, in case that the first-type impurities are n-type impurities, the second-type impurities may be p-type impurities.

Each of the well regions WA may include a source region SA corresponding to a source electrode of the pixel transistor PTR, a drain region DA corresponding to a drain electrode of the pixel transistor PTR, and a channel region CH disposed between the source region SA and the drain region DA.

A bottom insulating film BINS may be disposed between a gate electrode GE of the pixel transistor PTR and the well region WA. Side surface insulating films SIF may be disposed on side surfaces of the gate electrode GE. The side surface insulating films SIF may be disposed on the bottom insulating film BINS.

Each of the source region SA and the drain region DA may be a region doped with the first-type impurities. A gate electrode GE of the pixel transistor PTR may overlap the well region WA in the third direction DR3. The channel region CH may overlap the gate electrode GE in the third direction DR3. The source region SA of the pixel transistor PTR may be disposed on a side of the gate electrode GE, and the drain region DA may be disposed on another side of the gate electrode GE.

Each of the well regions WA may further include a first low-concentration impurity region LDD1 disposed between the channel region CH and the source region SA and a second low-concentration impurity region LDD2 disposed between the channel region CH and the drain region DA. The first low-concentration impurity region LDD1 may be a region having an impurity concentration lower than the source region SA due to the bottom insulating film BINS. The second low-concentration impurity region LDD2 may be a region having an impurity concentration lower than the drain region DA due to the bottom insulating film BINS. A distance between the source region SA and the drain region DA may increase by the first low-concentration impurity region LDD1 and the second low-concentration impurity region LDD2. Therefore, a length of the channel region CH of each of the pixel transistors PTR may increase, and thus, punch-through and hot carrier phenomena caused by a short channel may be prevented.

A first semiconductor insulating film SINS1 of the semiconductor insulating films may be disposed on the semiconductor substrate SSUB. The first semiconductor insulating film SINS1 may include (or be formed as) a silicon carbonitride (SiCN) or silicon oxide (SiOₓ)-based inorganic film, but embodiment of the disclosures are not limited thereto.

A second semiconductor insulating film SINS2 of the semiconductor insulating films may be disposed on the first semiconductor insulating film SINS1. The second semiconductor insulating film SINS2 may include (or be formed as) a silicon oxide (SiOₓ)-based inorganic film, but embodiments of the disclosure are not limited thereto.

The contact terminals CTE may be disposed on the second semiconductor insulating film SINS2. Each of the contact terminals CTE may be electrically connected to any one of the gate electrode GE, the source region SA, and the drain region DA of each of the pixel transistors PTR through a hole penetrating through the first semiconductor insulating film SINS 1 and the second semiconductor insulating film INS2. Each of the contact terminals CTE may include at least one of copper (Cu), aluminum (Al), tungsten (W), molybdenum (Mo), chromium (Cr), gold (Au), titanium (Ti), nickel (Ni), and neodymium (Nd). However, embodiments of the disclosure are not limited thereto, and each of the contact terminals CTE may include an alloy of the above-described metals.

A third semiconductor insulating film SINS3 of the semiconductor insulating films may be disposed on side surfaces of each of the contact terminals CTE. An upper surface of each of the contact terminals CTE may be exposed without being covered by the third semiconductor insulating film SINS3. The third semiconductor insulating film SINS3 may include (or be formed as) a silicon oxide (SiOₓ)-based inorganic film, but embodiments of the disclosure are not limited thereto.

The semiconductor substrate SSUB may be replaced with a glass substrate or a polymer resin substrate such as a polyimide substrate. Thin film transistors may be disposed on the glass substrate or the polymer resin substrate. The glass substrate may be a rigid substrate that is not bent, and the polymer resin substrate may be a flexible substrate that may be bent or curved.

The light emitting element backplane EBP may include conductive layers ML1 to ML8, vias VA1 to VA9, and insulating films INS1 to INS9. The insulating films INS1 to INS9 may be disposed between first to eighth conductive layers ML1 to ML8.

The first to eighth conductive layers ML1 to ML8 may form (or implement) a circuit of the first pixel PX1 illustrated in FIG. 3 by electrically connecting the contact terminals CTE exposed from the semiconductor backplane SBP to each other. For example, the first to sixth transistors T1 to T6 may be formed in the semiconductor backplane SBP, and the electrical connection between the first to sixth transistors T1 to T6 and the formation of the first capacitor C1 and the second capacitor C2 may be formed (or performed) through the first to eighth conductive layers ML1 to ML8. The electrical connection between a drain region corresponding to a drain electrode of the fourth transistor T4, a source region corresponding to a source electrode of the fifth transistor T5, and a first electrode of a light emitting element LE may be performed through the first to eighth conductive layers ML1 to ML8.

A first insulating film INS1 of the insulating films INS1 to INS9 may be disposed on the semiconductor backplane SBP. Each of first vias VA1 may penetrate through the first insulating film INS1 to be electrically connected to the contact terminal CTE exposed from the semiconductor backplane SBP. Each of the first conductive layers ML1 may be disposed on the first insulating film INS1 and be electrically connected to the first via VA1.

A second insulating film INS2 of the insulating films INS1 to INS9 may be disposed on the first insulating film INS1 and the first conductive layers ML1. Each of second vias VA2 may penetrate through the second insulating film INS2 to be electrically connected to the exposed first conductive layer ML1. Each of the second conductive layers ML2 may be disposed on the second insulating film INS2 and be electrically connected to the second via VA2.

A third insulating film INS3 of the insulating films INS1 to INS9 may be disposed on the second insulating film INS2 and the second conductive layers ML2. Each of third vias VA3 may penetrate through the third insulating film INS3 to be electrically connected to the exposed second conductive layer ML2. Each of the third conductive layers ML3 may be disposed on the third insulating film INS3 and be electrically connected to the third via VA3.

A fourth insulating film INS4 of the insulating films INS1 to INS9 may be disposed on the third insulating film INS3 and the third conductive layers ML3. Each of fourth vias VA4 may penetrate through the fourth insulating film INS4 to be electrically connected to the exposed third conductive layer ML3. Each of the fourth conductive layers ML4 may be disposed on the fourth insulating film INS4 and be electrically connected to the fourth via VA4.

A fifth insulating film INS5 of the insulating films INS1 to INS9 may be disposed on the fourth insulating film INS4 and the fourth conductive layers ML4. Each of fifth vias VA5 may penetrate through the fifth insulating film INS5 to be electrically connected to the exposed fourth conductive layer ML4. Each of the fifth conductive layers ML5 may be disposed on the fifth insulating film INS5 and be electrically connected to the fifth via VAS.

A sixth insulating film INS6 of the insulating films INS1 to INS9 may be disposed on the fifth insulating film INS5 and the fifth conductive layers ML5. Each of sixth vias VA6 may penetrate through the sixth insulating film INS6 to be electrically connected to the exposed fifth conductive layer ML5. Each of the sixth conductive layers ML6 may be disposed on the sixth insulating film INS6 and be electrically connected to the sixth via VA6.

A seventh insulating film INS7 of the insulating films INS 1 to INS9 may be disposed on the sixth insulating film INS6 and the sixth conductive layers ML6. Each of seventh vias VA7 may penetrate through the seventh insulating film INS7 to be electrically connected to the exposed sixth conductive layer ML6. Each of the seventh conductive layers ML7 may be disposed on the seventh insulating film INS7 and be electrically connected to the seventh via VA7.

An eighth insulating film INS8 of the insulating films INS 1 to INS9 may be disposed on the seventh insulating film INS7 and the seventh conductive layers ML7. Each of eighth vias VA8 may penetrate through the eighth insulating film INS8 to be electrically connected to the exposed seventh conductive layer ML7. Each of the eighth conductive layers ML8 may be disposed on the eighth insulating film INS8 and be electrically connected to the eighth via VA8.

The first to eighth conductive layers ML1 to ML8 and the first to eighth vias VA1 to VA8 may include substantially the same or similar material. Each of the first to eighth conductive layers ML1 to ML8 and the first to eighth vias VA1 to VA8 may include at least one of copper (Cu), aluminum (Al), tungsten (W), molybdenum (Mo), chromium (Cr), gold (Au), titanium (Ti), nickel (Ni), and neodymium (Nd). However, embodiments of the disclosure are not limited thereto, and each of the first to eighth conductive layers ML1 to ML8 and the first to eighth vias VA1 to VA8 may include an alloy of the above-described metals. The first to eighth vias VA1 to VA8 may include substantially the same or similar material. The first to eighth insulating films INS1 to INS8 may include (or be formed as) silicon oxide (SiOₓ)-based inorganic films, but embodiments of the disclosure are not limited thereto.

Each of a thickness of the first conductive layer ML1, a thickness of the second conductive layer ML2, a thickness of the third conductive layer ML3, a thickness of the fourth conductive layer ML4, a thickness of the fifth conductive layer ML5, and a thickness of the sixth conductive layer ML6 may be greater than each of a thickness of the first via VA1, a thickness of the second via VA2, a thickness of the third via VA3, a thickness of the fourth via VA4, a thickness of the fifth via VA5, and a thickness of the sixth via VA6. For example, the thicknesses of the first to sixth conductive layers ML1 to ML6 may be greater than those of the first to sixth vias VA1 to VA6, respectively. Each of the thickness of the second conductive layer ML2, the thickness of the third conductive layer ML3, the thickness of the fourth conductive layer ML4, the thickness of the fifth conductive layer ML5, and the thickness of the sixth conductive layer ML6 may be greater than the thickness of the first conductive layer ML1. The thickness of the second conductive layer ML2, the thickness of the third conductive layer ML3, the thickness of the fourth conductive layer ML4, the thickness of the fifth conductive layer ML5, and the thickness of the sixth conductive layer ML6 may be substantially the same as or similar to each other. For example, the thickness of the first conductive layer ML1 may be about 1,360 Å, each of the thickness of the second conductive layer ML2, the thickness of the third conductive layer ML3, the thickness of the fourth conductive layer ML4, the thickness of the fifth conductive layer ML5, and the thickness of the sixth conductive layer ML6 may be about 1,440 Å, and each of the thickness of the first via VA1, the thickness of the second via VA2, the thickness of the third via VA3, the thickness of the fourth via VA4, the thickness of the fifth via VA5, and the thickness of the sixth via VA6 may be about 1,150 Å.

Each of a thickness of the seventh conductive layer ML7 and a thickness of the eighth conductive layer ML8 may be greater than each of the thickness of the first conductive layer ML1, the thickness of the second conductive layer ML2, the thickness of the third conductive layer ML3, the thickness of the fourth conductive layer ML4, the thickness of the fifth conductive layer ML5, and the thickness of the sixth conductive layer ML6. Each of the thickness of the seventh conductive layer ML7 and the eighth conductive layer ML8 may be greater than each of a thickness of the seventh via VA7 and a thickness of the eighth via VA8. Each of the thickness of the seventh via VA7 and the thickness of the eighth via VA8 may be greater than each of the thickness of the first via VA1, the thickness of the second via VA2, the thickness of the third via VA3, the thickness of the fourth via VA4, the thickness of the fifth via VA5, and the thickness of the sixth via VA6. The thickness of the seventh conductive layer ML7 and the thickness of the eighth conductive layer ML8 may be substantially the same as (or similar to) each other. For example, each of the thickness of the seventh conductive layer ML7 and the thickness of the eighth conductive layer ML8 may be about 9,000 Å. Each of the thickness of the seventh via VA7 and the thickness of the eighth via VA8 may be about 6,000 Å.

A ninth insulating film INS9 of the insulating films INS 1 to INS9 may be disposed on the eighth insulating film INS8 and the eighth conductive layer ML8. The ninth insulating film INS9 may include (or be formed as) a silicon oxide (SiOₓ)-based inorganic film, but embodiments of the disclosure are not limited thereto.

Each of ninth vias VA9 may penetrate through the ninth insulating film INS9 to be electrically connected to the exposed eighth conductive layer ML8. Each of the ninth vias VA9 may include at least one of copper (Cu), aluminum (Al), tungsten (W), molybdenum (Mo), chromium (Cr), gold (Au), titanium (Ti), nickel (Ni), and neodymium (Nd). However, embodiments of the disclosure are not limited thereto, and each of the ninth vias VA9 may include an alloy of the above-described metals. A thickness of the ninth via VA9 may be about 16,500 Å.

The display element layer EMTL may be disposed on the light emitting element backplane EBP. The display element layer EMTL may include a reflective electrode layer RL, tenth and eleventh insulating films INS 10 and INS 11, tenth vias VA10, light emitting elements LE, a pixel defining film PDL, and trenches TRC. Each of the light emitting elements LE may include a first electrode AND, a light emitting stack ES, and a second electrode CAT.

The reflective electrode layer RL may be disposed on the ninth insulating film INS9. The reflective electrode layer RL may include one or more reflective electrodes RL1, RL2, RL3, and RL4. For example, the reflective electrode layer RL may include first to fourth reflective electrodes RL1, RL2, RL3, and RL4 as illustrated in FIG. 7.

Each of the first reflective electrodes RL1 may be disposed on the ninth insulating film INS9 and be electrically connected to the ninth via VA9. Each of the first reflective electrodes RL1 may include at least one of copper (Cu), aluminum (Al), tungsten (W), molybdenum (Mo), chromium (Cr), gold (Au), titanium (Ti), nickel (Ni), and neodymium (Nd). However, embodiments of the disclosure are not limited thereto, and each of the first reflective electrodes RL1 may include an alloy of the above-described metals. For example, each of the first reflective electrodes RL1 may include titanium nitride (TiN).

Each of the second reflective electrodes RL2 may be disposed on the first reflective electrode RL1. Each of the second reflective electrodes RL2 may include at least one of copper (Cu), aluminum (Al), tungsten (W), molybdenum (Mo), chromium (Cr), gold (Au), titanium (Ti), nickel (Ni), and neodymium (Nd). However, embodiments of the disclosure are not limited thereto, and each of the second reflective electrodes RL2 may include an alloy of the above-described metals. For example, each of the second reflective electrodes RL2 may include aluminum (Al).

Each of the third reflective electrodes RL3 may be disposed on the second reflective electrode RL2. Each of the third reflective electrodes RL3 may include at least one of copper (Cu), aluminum (Al), tungsten (W), molybdenum (Mo), chromium (Cr), gold (Au), titanium (Ti), nickel (Ni), and neodymium (Nd). However, embodiments of the disclosure are not limited thereto, and each of the third reflective electrodes RL3 may include an alloy of the above-described metals. For example, each of the third reflective electrodes RL3 may include titanium nitride (TiN).

Each of the fourth reflective electrodes RL4 may be disposed on the third reflective electrode RL3. Each of the fourth reflective electrodes RL4 may include at least one of copper (Cu), aluminum (Al), tungsten (W), molybdenum (Mo), chromium (Cr), gold (Au), titanium (Ti), nickel (Ni), and neodymium (Nd). However, embodiments of the disclosure are not limited thereto, and each of the fourth reflective electrodes RL4 may include an alloy of the above-described metals. For example, each of the fourth reflective electrodes RL4 may include titanium (Ti).

Since the second reflective electrodes RL2 are electrodes substantially reflecting light from the light emitting elements LE, a thickness of the second reflective electrode RL2 may be greater than a thickness of the first reflective electrode RL1, a thickness of the third reflective electrode RL3, and a thickness of the fourth reflective electrode RL4. For example, the thickness of the first reflective electrode RL1, the third reflective electrode RL3, and the fourth reflective electrode RL4 may be about 100 Å, and the thickness of the second reflective electrode RL2 may be about 850 Å.

The tenth insulating film INS10 may be disposed on the ninth insulating film INS9. The tenth insulating film INS 10 may be disposed between the reflective electrode layers RL adjacent to each other in a horizontal direction. The tenth insulating film INS10 may be disposed on the reflective electrode layer RL in the third pixel PX3. The tenth insulating film INS10 may include (or be formed as) a silicon oxide (SiOₓ)-based inorganic film, but embodiments of the disclosure are not limited thereto.

The eleventh insulating film INS 11 may be disposed on the tenth insulating film INS10 and the reflective electrode layer RL. The eleventh insulating film INS 11 may include (or be formed as) a silicon oxide (SiOₓ)-based inorganic film, but embodiments of the disclosure are not limited thereto. The tenth insulating film INS 10 and the eleventh insulating film INS 11 may be optical auxiliary layers through which light reflected by the reflective electrode layer RL among light emitted from the light emitting elements LE passes.

To adjust a resonance distance of the light emitted from the light emitting elements LE in at least one of the first pixel PX1, the second pixel PX2, and the third pixel PX3, the tenth insulating film INS 10 and the eleventh insulating film INS 11 may not be disposed below the first electrode AND of the first pixel PX1. For example, the tenth insulating film INS 10 and the eleventh insulating film INS 11 may be omitted, and the resonance distance of the light emitted from the light emitting elements LE in at least one of the first to third pixels PX1 to PX3 may be adjusted. The first electrode AND of the first pixel PX1 may be disposed on (e.g., directly disposed on) the reflective electrode layer RL. The eleventh insulating film INS 11 may be disposed below the first electrode AND of the second pixel PX2. The tenth insulating film INS 10 and the eleventh insulating film INS 11 may be disposed below the first electrode AND of the third pixel PX3.

A distance between the first electrode AND and the reflective electrode layer RL may be different in each of the first pixel PX1, the second pixel PX2, and the third pixel PX3. For example, to adjust a distance from the reflective electrode layer RL to the second electrode CAT according to a main wavelength of light emitted from each of the first pixel PX1, the second pixel PX2, and third pixel PX3, the presence or absence of the tenth insulating film INS10 and the eleventh insulating film INS 11 may be set in each of the first pixel PX1, the second pixel PX2, and the third pixel PX3. For example, In FIG. 7, a distance between the first electrode AND and the reflective electrode layer RL in the third pixel PX3 may be greater than a distance between the first electrode AND and the reflective electrode layer RL in the second pixel PX2, and a distance between the first electrode AND and the reflective electrode layer RL in the first pixel PX1 and the distance between the first electrode AND and the reflective electrode layer RL in the second pixel PX2 may be greater than the distance between the first electrode AND and the reflective electrode layer RL in the first pixel PX1. However, embodiments of the disclosure are not limited thereto.

In FIG. 7, the tenth insulating film INS10 and the eleventh insulating film INS 11 may be disposed on the light emitting backplane EBP. However, embodiments of the disclosure are not limited thereto, and a twelfth insulating film may be disposed below the first electrode AND of the first pixel PX1. The eleventh insulating film INS11 and the twelfth insulating film may be disposed below the first electrode AND of the second pixel PX2, and the tenth insulating film INS 10, the eleventh insulating film INS 11, and the twelfth insulating film may be disposed below the first electrode AND of the third pixel PX3.

Each of the tenth vias VA10 may penetrate through the tenth insulating film INS10 and/or the eleventh insulating film INS 11 in the second pixel PX2 and the third pixel PX3 to be electrically connected to the exposed fourth reflective electrode RL4. Each of the tenth vias VA10 may include at least one of copper (Cu), aluminum (Al), tungsten (W), molybdenum (Mo), chromium (Cr), gold (Au), titanium (Ti), nickel (Ni), and neodymium (Nd). However, embodiments of the disclosure are not limited thereto, and each of the tenth vials VA10 may include an alloy of the above-described metals. A thickness of the tenth via VA10 in the second pixel PX2 may be smaller than a thickness of the tenth via VA10 in the third pixel PX3.

The first electrode AND of each of the light emitting elements LE may be disposed on the tenth insulating film INS 10 and be electrically connected to the tenth via VA10. The first electrode AND of each of the light emitting elements LE may be electrically connected to the drain region DA or the source region SA of the pixel transistor PTR through the tenth via VA10, the first to fourth reflective electrodes RL1 to RL4, the first to ninth vias VA1 to VA9, the first to eighth conductive layers ML1 to ML8, and the contact terminal CTE. The first electrode AND of each of the light emitting elements LE may include at least one of copper (Cu), aluminum (Al), tungsten (W), molybdenum (Mo), chromium (Cr), gold (Au), titanium (Ti), nickel (Ni), and neodymium (Nd). However, embodiments of the disclosure are not limited thereto, and the first electrode AND of each of the light emitting elements LE may include an alloy of the above-described metals. For example, the first electrode AND of each of the light emitting elements LE may include titanium nitride (TiN).

The pixel defining film PDL may be disposed on a partial area of the first electrode AND of each of the light emitting elements LE. The pixel defining film PDL may cover an edge of the first electrode AND of each of the light emitting elements LE. The pixel defining film PDL may partition the first emission areas EA1, the second emission areas EA2, and the third emission areas EA3. For example, the pixel defining film PDL may be disposed adjacent ones of the first to third emission areas EA1 to EA3.

The first emission area EA1 may be defined as an area where the first electrode AND, the light emitting stack ES, and the second electrode CAT are sequentially stacked each other in the first pixel PX1 to emit light. The second emission area EA2 may be defined as an area where the first electrode AND, the light emitting stack ES, and the second electrode CAT are sequentially stacked each other in the second pixel PX2 to emit light. The third emission area EA3 may be defined as an area where the first electrode AND, the light emitting stack ES, and the second electrode CAT are sequentially stacked each other in the third pixel PX3 to emit light.

The pixel defining film PDL may include first to third pixel defining films PDL1, PDL2, and PDL3. The first pixel defining film PDL1 may be disposed on the edge of the first electrode AND of each of the light emitting elements LE. The second pixel defining film PDL2 may be disposed on the first pixel defining film PDL1. The third pixel defining film PDL3 may be disposed on the second pixel defining film PDL2. The first pixel defining film PDL1, the second pixel defining film PDL2, and the third pixel defining film PDL3 may include (or be formed as) silicon oxide (SiOₓ)-based inorganic films, but embodiments of the disclosure are not limited thereto. Each of a thickness of the first pixel defining film PDL1, a thickness of the second pixel defining film PDL2, and a thickness of the third pixel defining film PDL3 may be about 500 Å.

In case that the first pixel defining film PDL1, the second pixel defining film PDL2, and the third pixel defining film PDL3 are formed as a pixel defining film, a height of the pixel defining film may increase, and a first encapsulation inorganic film TFE1 may be electrically disconnected (or electrically insulated) due to step coverage. The step coverage refers to a ratio of a degree at which a thin film is coated on an inclined portion to a degree at which a thin film is coated on a flat portion. The lower the step coverage, the thin film may be electrically disconnected (or electrically insulated) at the inclined portion.

Therefore, to prevent the first encapsulation inorganic film TFE1 from being electrically disconnected (or electrically insulated) due to the step coverage, the first pixel defining film PDL1, the second pixel defining film PDL2, and the third pixel defining film PDL3 may have a cross-sectional structure with a step having a staircase shape (e.g., a shape having multiple steps). For example, a width of the first pixel defining film PDL1 may be greater than a width of the second pixel defining film PDL2 and a width of the third pixel defining film PDL3, and the width of the second pixel defining film PDL2 may be greater than the width of the third pixel defining film PDL3. The width of the first pixel defining film PDL1 refers to a length, in the horizontal direction, of the first pixel defining film PDL1 defined by the first direction DR1 and the second direction DR2.

Each of the trenches TRC may penetrate through the first pixel defining film PDL1, the second pixel defining film PDL2, and the third pixel defining film PDL3. Each of the trenches TRC may penetrate through the eleventh insulating film INS11. In each of the trenches TRC, the tenth insulating film INS 10 may have a shape in which a portion of the tenth insulating film INS 10 is trenched.

At least one trench TRC may be disposed between the pixels PX1, PX2, and PX3 adjacent to (or neighboring to) each other. For example, one or more trenches TRC may be disposed between adjacent ones of the first to third pixels PX1, PX2, and PX3. In FIG. 7, two trenches TRC may be disposed between the pixels PX1, PX2, and PX3 adjacent to (or neighboring to) each other, but embodiments of the disclosure are not limited thereto.

The light emitting stack ES may include stack layers. In FIG. 7, the light emitting stack ES may have a three-tandem structure (or a triple-tandem structure) including a first stack layer IL1, a second stack layer IL2, and a third stack layer IL3, but embodiments of the disclosure are not limited thereto. For example, the light emitting stack ES may have a two-tandem structure (or a double tandem structure) including two intermediate layers.

In the three-tandem structure (or the triple-tandem structure), the light emitting stack ES may have a tandem structure including stack layers IL1, IL2, and IL3 emitting different light. For example, the light emitting stack ES may include a first stack layer IL1 emitting light of a first color, a second stack layer IL2 emitting light of a third color, and a third stack layer IL3 emitting light of a second color. The first stack layer IL1, the second stack layer IL2, and the third stack layer IL3 may be sequentially stacked each other.

The first stack layer IL1 may have a structure in which a first hole transporting layer, a first organic light emitting layer emitting the light of the first color, and a first electron transporting layer are sequentially stacked each other. The second stack layer IL2 may have a structure in which a second hole transporting layer, a second organic light emitting layer emitting the light of the third color, and a second electron transporting layer are sequentially stacked each other. The third stack layer IL3 may have a structure in which a third hole transporting layer, a third organic light emitting layer emitting the light of the second color, and a third electron transporting layer are sequentially stacked each other.

A first charge generation layer for supplying charges to the second stack layer IL2 and supplying electrons to the first stack layer IL1 may be disposed between the first stack layer IL1 and the second stack layer IL2. The first charge generation layer may include an N-type charge generation layer supplying electrons to the first stack layer IL1 and a P-type charge generation layer supplying holes to the second stack layer IL2. The N-type charge generation layer may include a dopant of a metal material.

A second charge generation layer for supplying charges to the third stack layer IL3 and supplying electrons to the second stack layer IL2 may be disposed between the second stack layer IL2 and the third stack layer IL3. The second charge generation layer may include an N-type charge generation layer supplying electrons to the second stack layer IL2 and a P-type charge generation layer supplying holes to the third stack layer IL3.

The first stack layer IL1 may be disposed on the first electrodes AND and the pixel defining film PDL, and may be disposed on a bottom surface of each of the trenches TRC. Due to the trenches TRC, the first stack layer IL1 may be electrically disconnected (or electrically insulated) between the pixels PX1, PX2, and PX3 adjacent to (or neighboring to) each other. The second stack layer IL2 may be disposed on the first stack layer IL1. Due to the trenches TRC, the second stack layer IL2 may be electrically disconnected (or electrically insulated) between the pixels PX1, PX2, and PX3 adjacent to (or neighboring to) each other. A cavity ESS or an empty space may be disposed between the first stack layer IL1 and the second stack layer IL2. The third stack layer IL3 may be disposed on the second stack layer IL2. The third stack layer IL3 may not be electrically disconnected (or electrically insulated) by the trenches TRC, and may electrically cover the second stack layer IL2 in each of the trenches TRC. For example, in the three-tandem structure (or the triple-tandem structure), each of the trenches TRC may be a structure for electrically disconnecting the first and second stack layers IL1 and IL2, the first charge generation layer, and the second charge generation layer of the display element layer EMTL between the pixels PX1, PX2, and PX3 adjacent to (or neighboring to) each other. In the two-tandem structure (or a double tandem structure), each of the trenches TRC may be a structure for electrically disconnecting a charge generation layer disposed between a lower intermediate layer and an upper intermediate layer and the lower intermediate layer.

To stably disconnect the first and second stack layers IL1 and IL2 of the display element layer EMTL between the pixels PX1, PX2, and PX3 adjacent to (or neighboring to) each other, a height of each of the trenches TRC may be greater than a height of the pixel defining film PDL. The height of each of the trenches TRC refers to a length of each of the trenches TRC in the third direction DR3. The height of the pixel defining film PDL refers to a length of the pixel defining film PDL in the third direction DR3. However, embodiments of the disclosure are not limited thereto. To electrically disconnect the first and second intermediate layers IL1 and IL2 of the display element layer EMTL between the pixels PX1, PX2, and PX3 adjacent to (or neighboring to) each other, other structures may exist instead of the trenches TRC. For example, instead of the trenches TRC, partition walls or banks having a reverse tapered shape may be disposed on the pixel defining film PDL.

The number of stack layers IL1, IL2, and IL3 emitting the different light is not limited to that illustrated in FIG. 7. For example, the light emitting stack ES may include two intermediate layers. Any one of the two intermediate layers may be substantially the same as (or the similar to) the first stack layer IL1, and another of the two intermediate layers may include at least one of a second hole transporting layer, a second organic light emitting layer, a third organic light emitting layer, and a second electron transporting layer. A charge generation layer for supplying electrons to any one intermediate layer and supplying charges to another intermediate layer may be disposed between the two intermediate layers.

In FIG. 7, the first to third stack layers IL1, IL2, and IL3 may all be disposed in the first emission area EA1, the second emission area EA2, and the third emission area EA3, but embodiments of the disclosure are not limited thereto. For example, the first stack layer IL1 may be disposed in the first emission area EA1, and may not be disposed in the second emission area EA2 or the third emission area EA3. The second stack layer IL2 may be disposed in the second emission area EA2, and may not be disposed in the first emission area EA1 or the third emission area EA3. The third stack layer IL3 may be disposed in the third emission area EA3, and may not be disposed on the first emission area EA1 or the second emission area EA2. First to third color filters CF1, CF2, and CF3 of the optical layer OPL may be omitted.

The second electrode CAT may be disposed on the third stack layer IL3. The second electrode CAT may be disposed on the third stack layer IL3 in each of the trenches TRC. The second electrode CAT may include a transparent conductive material (TCO) such as indium tin oxide (ITO) or indium zinc oxide (IZO) capable of transmitting light through the second electrode CAT or a semi-transmissive conductive material such as magnesium (Mg), silver (Ag), or an alloy of magnesium (Mg) and silver (Ag). In case that the second electrode CAT includes the semi-transmissive conductive material, light emission efficiency of each of the first to third pixels PX1, PX2, and PX3 may be increased by a micro cavity.

The encapsulation layer TFE may be disposed on the display element layer EMTL. The encapsulation layer TFE may include at least one inorganic film TFE1 or TFE2 to prevent oxygen or moisture from permeating into the display element layer EMTL. For example, the encapsulation layer TFE may include a first encapsulation inorganic film TFE1 and a second encapsulation inorganic film TFE2.

The first encapsulation inorganic film TFE1 may be disposed on the second electrode CAT. The first encapsulation inorganic film TFE1 may include (or be formed as) multiple films in which one or more inorganic films of a silicon nitride (SiNₓ) layer, a silicon oxynitride (SiOₓN_{y}) layer, and a silicon oxide (SiOₓ) layer are alternately stacked each other. The first encapsulation inorganic film TFE1 may be formed by a chemical vapor deposition (CVD) process.

The second encapsulation inorganic film TFE2 may be disposed on the first encapsulation inorganic film TFE1. The second encapsulation inorganic film TFE2 may include (or be formed as) a titanium oxide (TiOₓ) layer or an aluminum oxide (AlOₓ) layer, but embodiments of the disclosure are not limited thereto. The second encapsulation inorganic film TFE2 may be formed by an atomic layer deposition (ALD) process. A thickness of the second encapsulation inorganic film TFE2 may be smaller than a thickness of the first encapsulation inorganic film TFE1.

An organic film APL may be a layer for increasing interfacial adhesive strength between the encapsulation layer TFE and the optical layer OPL. For example, the organic film APL may be disposed on the encapsulation layer TFE. The organic film APL may be an organic film including at least one of an acrylic resin, an epoxy resin, a phenolic resin, a polyamide resin, and a polyimide resin. However, embodiments of the disclosure are not limited thereto.

The optical layer OPL may include color filters CF1, CF2, and CF3, lenses LNS, and a filling layer FIL. For example, the optical layer OPL may be disposed on the organic film APL. The color filters CF1, CF2, and CF3 may include first to third color filters CF1, CF2, and CF3. The first to third color filters CF1, CF2, and CF3 may be disposed on the organic film APL.

The first color filter CF1 may overlap the first emission area EA1 of the first pixel PX1 in a plan view. The first color filter CF1 may transmit the light of the first color (e.g., the light of the blue wavelength band). The blue wavelength band may be in a range of about 370 nm to about 460 nm. Therefore, the first color filter CF1 may transmit the light of the first color among light emitted from the first emission area EA1 through the first color filter CF1.

The second color filter CF2 may overlap the second emission area EA2 of the second pixel PX2 in a plan view. The second color filter CF2 may transmit the light of the second color (e.g., the light of the green wavelength band). The green wavelength band may be in a range of about 480 nm to about 560 nm. Therefore, the second color filter CF2 may transmit the light of the second color among light emitted from the second emission area EA2 through the second color filter CF2.

The third color filter CF3 may overlap the third emission area EA3 of the third pixel PX3 in a plan view. The third color filter CF3 may transmit the light of the third color (e.g., the light of the red wavelength band). The red wavelength band may be in a range of about 600 nm to about 750 nm. Therefore, the third color filter CF3 may transmit the light of the third color among light emitted from the third emission area EA3 through the third color filter CF3.

Each of the lenses LNS may be disposed on each of the first color filter CF1, the second color filter CF2, and the third color filter CF3. Each of the lenses LNS may have a structure for increasing a ratio of light directed to a front surface of the display device 10. For example, the lenses LNS may guide light towards the front surface of the display device. Each of the lenses LNS may have a cross-sectional shape convex in an upward direction.

The filling layer FIL may be disposed on the lenses LNS. The filling layer FIL may have a refractive index (e.g., a predetermined or selectable refractive index), and light may travel (be guided) in the third direction DR3 at an interface between the lenses LNS and the filling layer FIL. The filling layer FIL may be a planarizing layer. The filling layer FIL may be an organic film including at least one of an acrylic resin, an epoxy resin, a phenolic resin, a polyamide resin, and a polyimide resin. However, embodiments of the disclosure are not limited thereto.

The cover layer CVL may be disposed on the filling layer FIL. The cover layer CVL may be a glass substrate or a polymer resin substrate. In case that the cover layer CVL is the glass substrate, the cover layer CVL may be attached onto the filling layer FIL. The filling layer FIL may adhere the cover layer CVL. In case that the cover layer CVL is the glass substrate, the cover layer CVL may form (or serve as) an encapsulation substrate. In case that the cover layer CVL is the polymer resin, the cover layer CVL may be applied onto (e.g., directly applied onto) the filling layer FIL.

The polarizing plate POL may be disposed on a surface (e.g., an upper surface) of the cover layer CVL. The polarizing plate POL may be a structure for preventing deterioration in visibility due to external light reflection. The polarizing plate POL may include a linear polarizing plate and a phase retardation film. For example, the phase retardation film may be a λ/4 plate (e.g., a quarter-wave plate), but embodiments of the disclosure are not limited thereto. However, in case that visibility due to external light reflection is sufficiently improved by the first to third color filters CF1, CF2, and CF3, the polarizing plate POL may be omitted.

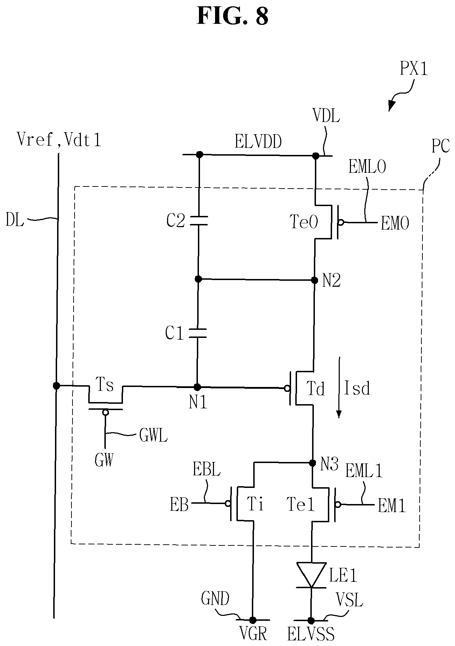

FIG. 8 is a schematic diagram of an equivalent circuit illustrating a first pixel PX1 according to an embodiment.

As illustrated in FIG. 8, the first pixel PX1 may include a pixel circuit PC and a first light emitting element LE1 electrically connected to the pixel circuit PC of the first pixel PX1.

The pixel circuit PC may include a driving transistor Td, a switching transistor Ts, a common emission control transistor Te0, a first emission control transistor Te1, an initialization transistor Ti, a first capacitor C1, and a second capacitor C2.

The driving transistor Td may include a gate electrode, a source electrode, and a drain electrode. The driving transistor Td may control a source-drain current Isd according to the data voltage Vdt1 applied to the gate electrode. The driving current Isd flowing through a channel region of the driving transistor Td may be proportional to the square of a difference between the threshold voltage and the voltage between the source electrode and the gate electrode of the driving transistor Td. The gate electrode of the driving transistor Td may be electrically connected to a first node N1, the source electrode of the driving transistor Td may be electrically connected to a second node N2, and the drain electrode of the riving transistor Td may be electrically connected to a third node N3.

The first light emitting element LE1 may emit light by receiving the driving current Isd. The emission amount or the luminance of the first light emitting element LE1 may be proportional to the magnitude of the driving current Isd. The first light emitting element LE1 may be an organic light emitting diode including a first electrode (e.g., anode electrode), a second electrode (e.g., cathode electrode), and an organic light emitting layer disposed between the first electrode and the second electrode. For another example, the first light emitting element LE1 may be an inorganic light emitting element including a first electrode, a second electrode, and an inorganic semiconductor disposed between the first electrode and the second electrode. In other embodiments, the first light emitting element LE1 may be a quantum dot light emitting element including a first electrode, a second electrode, and a quantum dot light emitting layer disposed between the first electrode and the second electrode. In other embodiments, the first light emitting element LE1 may be a micro light emitting diode. The first electrode of the first light emitting element LE1 may be electrically connected to the drain electrode of the first emission control transistor Te1. The second electrode of the first light emitting element LE1 may be electrically connected to a common voltage line VSL that transmits a common voltage ELVSS.

The switching transistor Ts may be turned on by a write scan signal GW of the write scan line GWL and electrically connect the data line DL to a first node N1. The gate electrode of the switching transistor Ts may be electrically connected to the write scan line GWL, the source electrode of the switching transistor Ts may be electrically connected to the data line DL, and the drain electrode of the switching transistor Ts may be electrically connected to the first node N1. The data line DL may transmit a data voltage Vdt1 or a reference voltage Vref. The reference voltage Vref and the data voltage Vdt1, for example, may be provided to the data line DL from the data driver 700 (e.g., refer to FIG. 4).

The common emission control transistor Te0 may be turned on by a common emission control signal EM0 of a common emission control line EML0 and electrically connect the driving voltage line VDL to the second node N2. The gate electrode of the common emission control transistor Te0 may be electrically connected to the common emission control line EML0, the source electrode of the common emission control transistor Te0 may be electrically connected to the driving voltage line VDL, and the drain electrode of the common emission control transistor Te0 may be electrically connected to the second node N2.

The first emission control transistor Te1 may be turned on by a first emission control signal EM1 of a first emission control line EML1 and electrically connect the anode electrode of the first light emitting element LE1 to a third node N3. The gate electrode of the first emission control transistor Te1 may be electrically connected to the first emission control line EML1, the source electrode of the first emission control transistor Te1 may be electrically connected to the third node N3, and the drain electrode of the first emission control transistor Te1 may be electrically connected to the anode electrode of the first light emitting element LE1.

The initialization transistor Ti may be turned on by a bias scan signal EB of a bias scan line EBL and electrically connect a ground GND to the third node N3. The gate electrode of the initialization transistor Ti may be electrically connected to the bias scan line EBL, the source electrode of the initialization transistor Ti may be electrically connected to the third node N3, and the drain electrode of the initialization transistor Ti may be electrically connected to the ground GND. The ground GND may provide a ground voltage VGR.

The first capacitor C1 may be electrically connected between the first node N1 and the second node N2. For example, the first electrode of the first capacitor C1 may be electrically connected to the first node N1, and the second electrode of the first capacitor C1 may be electrically connected to the second node N2.

The second capacitor C2 may be electrically connected between the second node N2 and the driving voltage line VDL. For example, the first electrode of the second capacitor C2 may be electrically connected to the second node N2, and the second electrode of the second capacitor C2 may be electrically connected to the driving voltage line VDL.

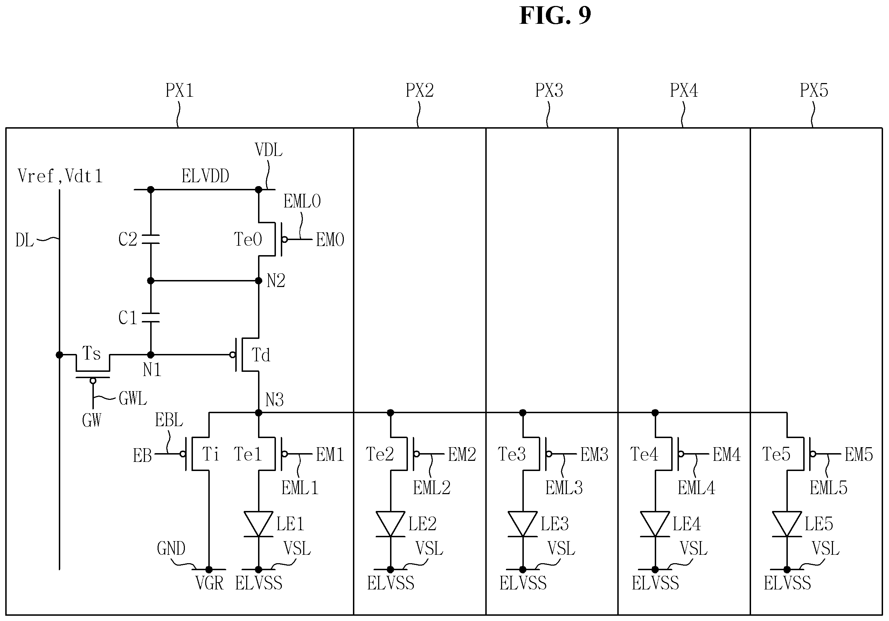

FIG. 9 is a schematic diagram of an equivalent circuit illustrating second, third, fourth, and fifth pixels PX2, PX3, PX4, and PX5 electrically connected to the first pixel PX1 of FIG. 8.

In case that the first pixel PX1 is defined as a main pixel and the second to fifth pixels PX2 to PX5 electrically connected to the first pixel PX1 are defined as sub-pixels, the main pixel and the sub-pixels may have different configurations. For example, as described above, the main pixel (e.g., the first pixel PX1) may include a driving transistor Td, a switching transistor Ts, a common emission control transistor Te0, a first emission control transistor Te1, an initialization transistor Ti, a first capacitor C1, a second capacitor C2, and a first light emitting element LE1, and each of the sub-pixels (e.g., the second to fifth pixels PX2 to PX5) may include an emission control transistor (e.g., each of second to fifth emission control transistors Te2 to Te5) and a light emitting element (e.g., each of second to fifth light emitting elements LE2 to LE5). Detained description of the sub-pixels (e.g., the second pixel PX2, the third pixel PX3, the fourth pixel PX4, and the fifth pixel PX5) is provided below.

The second pixel PX2 may include a second emission control transistor Te2 and a second light emitting element LE2.

The second emission control transistor Te2 may be turned on by a second emission control signal EM2 of a second emission control line EML2 and electrically connect the anode electrode of the second light emitting element LE2 to the third node N3. The gate electrode of the second emission control transistor Te2 may be electrically connected to the second emission control line EML2, the source electrode of the second emission control transistor Te2 may be electrically connected to the third node N3, and the drain electrode of the second emission control transistor Te2 may be electrically connected to the anode electrode of the second light emitting element LE2.

The third pixel PX3 may include a third emission control transistor Te3 and a third light emitting element LE3.

The third emission control transistor Te3 may be turned on by a third emission control signal EM3 of a third emission control line EML3 and electrically connect the anode electrode of the third light emitting element LE3 to the third node N3. The gate electrode of the third emission control transistor Te3 may be electrically connected to the third emission control line EML3, the source electrode of the third emission control transistor Te3 may be electrically connected to the third node N3, and the drain electrode of the third emission control transistor Te3 may be electrically connected to the anode electrode of the third light emitting element LE3.

The fourth pixel PX4 may include a fourth emission control transistor Te4 and a fourth light emitting element LE4.

The fourth emission control transistor Te4 may be turned on by a fourth emission control signal EM4 of a fourth emission control line EML4 and electrically connect the anode electrode of the fourth light emitting element LE4 to the third node N3. The gate electrode of the fourth emission control transistor Te4 may be electrically connected to the fourth emission control line EML4, the source electrode of the fourth emission control transistor Te4 may be electrically connected to the third node N3, and the drain electrode of the fourth emission control transistor Te4 may be electrically connected to the anode electrode of the fourth light emitting element LE4.

The fifth pixel PX5 may include a fifth emission control transistor Te5 and a fifth light emitting element LE5.

The fifth emission control transistor Te5 may be turned on by a fifth emission control signal EM5 of a fifth emission control line EML5 and electrically connect the anode electrode of the fifth light emitting element LE5 to the third node N3. The gate electrode of the fifth emission control transistor Te5 may be electrically connected to the fifth emission control line EML5, the source electrode of the fifth emission control transistor Te5 may be electrically connected to the third node N3, and the drain electrode of the fifth emission control transistor Te5 may be electrically connected to the anode electrode of the fifth light emitting element LE5.

The number of the sub-pixels (e.g., the second to fifth pixels PX2 to PX5) electrically connected to a main pixel (e.g., the first pixel PX1) may vary. For example, the number of the sub-pixels electrically connected to the main pixel may be less than four. In other embodiments, the number of the sub-pixels electrically connected to the main pixel may be more than four.

All of the first to fifth pixels PX1 to PX5 electrically connected to each other may provide light of the same color. For example, the first to fifth light emitting elements LE1 to LE5 may all provide light of the same color. In other embodiments, at least two of the first to fifth pixels PX1 to PX5 may provide light of different colors. For example, at least two of the first to fifth light emitting elements LE1 to LE5 may provide light of different colors.

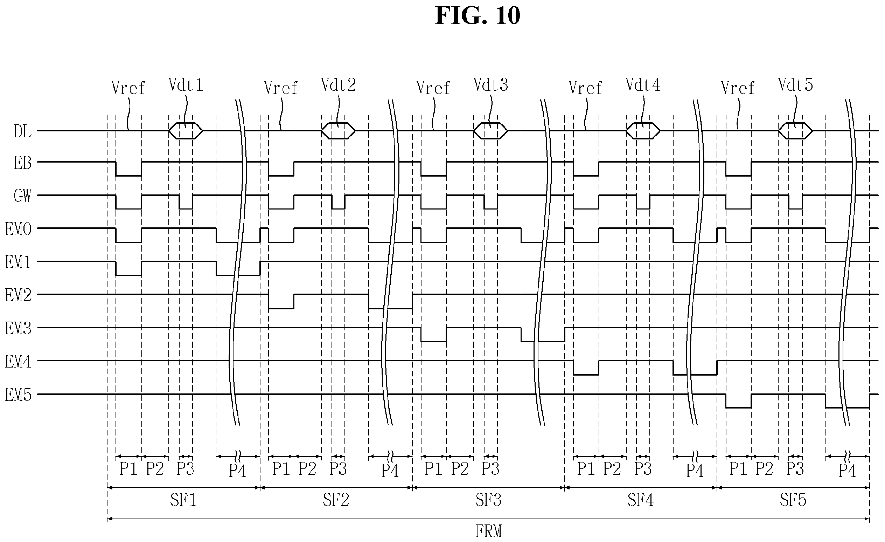

FIG. 10 is a schematic diagram illustrating an embodiment in respect to a timing diagram of a reference voltage Vref, data voltages Vdt1, Vdt2, Vdt3, Vdt4, and Vdt5, a bias scan signal EB, a write scan signal GW, a common emission control signal EM0, a first emission control signal EM1, a second emission control signal EM2, a third emission control signal EM3, a fourth emission control signal EM4, and a fifth emission control signal EM5 of FIG. 9.

The first pixel PX1, the second pixel PX2, the third pixel PX3, the fourth pixel PX4, and the fifth pixel PX5 may sequentially emit light during a frame period FRM. For example, the first pixel PX1, the second pixel PX2, the third pixel PX3, the fourth pixel PX4, and the fifth pixel PX5 may sequentially emit light in a time-division manner during each frame period FRM.

According to an embodiment, each frame period FRM may include a first sub-frame period SF1, a second sub-frame period SF2, a third sub-frame period SF3, a fourth sub-frame period SF4, and a fifth sub-frame period SF5. The first pixel PX1 may emit light during the first sub-frame period SF1, the second pixel PX2 may emit light during the second sub-frame period SF2, the third pixel PX3 may emit light during the third sub-frame period SF3, the fourth pixel PX4 may emit light during the fourth sub-frame period SF4, and the fifth pixel PX5 may emit light during the fifth sub-frame period SF5. According to an embodiment, in case that each pixel emits light during each sub-frame period, other pixels may maintain in a state of not emitting light (or may not emit light during the sub-frame period). For example, in the first sub-frame period SF1, only the first pixel PX1 among the first to fifth pixels PX1 to PX5 may selectively emit light, and the second to fifth pixels PX2 to PX5 (e.g., remaining pixels except the first pixel PX1) may be turned off. In the second sub-frame period SF2, only the second pixel PX2 among the first to fifth pixels PX1 to PX5 may selectively emit light, and the first pixel PX1, the third pixel PX3, the fourth pixel PX4 and the fifth pixel PX5 (e.g., remaining pixels except the second pixel PX2) may be turned off. In the third sub-frame period SF3, only the third pixel PX3 among the first to fifth pixels PX1 to PX5 may selectively emit light, and the first pixel PX1, the second pixel PX2, the fourth pixel PX4 and the fifth pixel PX5 (e.g., remaining pixels except the third pixel PX3) may be turned off. In the fourth sub-frame period SF4, only the fourth pixel PX4 among the first to fifth pixels PX1 to PX5 may selectively emit light, and the first pixel PX1, the second pixel PX2, the third pixel PX3 and the fifth pixel PX5 (e.g., remaining pixels except the fourth pixel PX4) may be turned off. In the fifth sub-frame period SF5, only the fifth pixel PX5 among the first to fifth pixels PX1 to PX5 may selectively emit light, and the first pixel PX1, the second pixel PX2, the third pixel PX3 and the fourth pixel PX4 (e.g., remaining pixels except the fifth pixel PX5) may be turned off.

According to an embodiment, each sub-frame period may include an initialization period P1, a threshold voltage detection period P2, a data writing period P3, and an emission period P4. For example, the first sub-frame period SF1 may include an initialization period P1, a threshold voltage detection period P2, a data writing period P3, and an emission period P4. Each of the second sub-frame period SF2, the third sub-frame period SF3, the fourth sub-frame period SF4, and the fifth sub-frame period SF5 may also include the aforementioned initialization period P1, a threshold voltage detection period P2, a data writing period P3 and an emission period P4.

The bias scan signal EB, the write scan signal GW, the common emission control signal EM0, the first emission control signal EM1, the second emission control signal EM2, the third emission control signal EM3, the fourth emission control signal EM4, and the fifth emission control signal EM5 may have an active level or a non-active level for each of periods P1, P2, P3, and P4. The active level of each of the above-described signals EB, GW, EM0, EM1, EM2, EM3, EM4, and EM5 may mean a voltage at a level capable of turning on the corresponding transistor to which the signal is applied. For example, the signal of the active level may have a value greater than the threshold value of the corresponding transistor. For example, as illustrated in FIG. 9, in case that each of the transistors Td, Ts, Te0, Te1, Te2, Te3, Te4, Te5, and Ti is a P-type transistor, the active level of each of the signals EB, GW, EM0, EM1, EM2, EM3, EM4, and EM5 may mean a low level (e.g., negative polarity level or low voltage level).

For example, the non-active level of each of the signals EB, GW, EM0, EM1, EM2, EM3, EM4, and EM5 may mean a voltage at a level capable of turning off the corresponding transistor. For example, the signal of the non-active level may have a value smaller than the threshold voltage of the corresponding transistor. For example, as illustrated in FIG. 9, in case that each of the transistors Td, Ts, Te0, Te1, Te2, Te3, Te4, Te5, and Ti is a P-type transistor, the non-active level of each of the signals EB, GW, EM0, EM1, EM2, EM3, EM4, and EM5 may mean a high level (e.g., positive polarity level or high voltage level).

In other embodiments, in case that each of the transistors Td, Ts, Te0, Te1, Te2, Te3, Te4, Te5, and Ti is an N-type transistor, the active level of each of the signals EB, GW, EM0, EM1, EM2, EM3, EM4, and EM5 may mean the high level (e.g., positive polarity level or high voltage level), and the non-active level of each of the signals EB, GW, EM0, EM1, EM2, EM3, EM4, and EM5 may mean the low level (e.g., negative polarity level or low voltage level).

In the initialization period P1 of the first sub-frame period SF1, each of the bias scan signal EB, the write scan signal GW, the common emission control signal EM0 and the first emission control signal EM1 may have the active level, and each of the second emission control signal EM2, the third emission control signal EM3, the fourth emission control signal EM4, and the fifth emission control signal EM5 may have the non-active level. In the initialization period P1 of the first sub-frame period SF1, the reference voltage Vref may be applied to the data line DL.

In the threshold voltage detection period P2 of the first sub-frame period SF1, the common emission control signal EM0, the bias scan signal EB, the write scan signal GW, the first emission control signal EM1, the second emission control signal EM2, the third emission control signal EM3, the fourth emission control signal EM4, and the fifth emission control signal EM5 may each have the non-active level. In the threshold voltage detection period P2 of the first sub-frame period SF1, the reference voltage Vref may be applied to the data line DL.

In the data writing period P3 of the first sub-frame period SF1, the write scan signal GW may have the active level, and the bias scan signal EB, the first emission control signal EM1, the second emission control signal EM2, the third emission control signal EM3, the fourth emission control signal EM4, and the fifth emission control signal EM5 may each have the non-active level. In the data writing period P3 of the first sub-frame period SF1, the first data voltage Vdt1 may be applied to the data line DL.

In the emission period P4 of the first sub-frame period SF1, each of the common emission control signal EM0 and the first emission control signal EM1 may have the active level, and each of the bias scan signal EB, the write scan signal GW, the second emission control signal EM2, the third emission control signal EM3, the fourth emission control signal EM4, and the fifth emission control signal EM5 may have the non-active level. In the emission period P4 of the first sub-frame period SF1, the reference voltage Vref may be applied to the data line DL.

According to an embodiment, other signals except the first to fifth emission control signals EM1 to EM5 (e.g., bias scan signal EB, write scan signal GW, common emission control signal EM0) may have the same timing in the remaining sub-frame periods (e.g., second to fifth sub-frame periods SF2 to SF5) as the above-described first sub-frame period SF1. For example, the first emission control signal EM1 may remain as the non-active level during the remaining sub-frame periods except the first sub-frame period SF1 (e.g., initialization period P1 of the first sub-frame period SF1 and emission period P4 of the first sub-frame period SF1). The second emission control signal EM2 may remain as the non-active level during the remaining sub-frame periods except the second sub-frame period SF2 (e.g., initialization period P1 of the second sub-frame period SF2 and emission period P4 of the second sub-frame period SF2). The third emission control signal EM3 may remain as the non-active level during the remaining sub-frame periods except the third sub-frame period SF3 (e.g., initialization period P1 of the third sub-frame period SF3 and emission period P4 of the third sub-frame period SF3). The fourth emission control signal EM4 may remain as the non-active level during the remaining sub-frame periods except the fourth sub-frame period SF4 (e.g., initialization period P1 of the fourth sub-frame period SF4 and emission period P4 of the fourth sub-frame period SF4). The fifth emission control signal EM5 may remain as the non-active level during the remaining sub-frame periods except the fifth sub-frame period SF5 (e.g., initialization period P1 of the fifth sub-frame period SF5 and emission period P4 of the fifth sub-frame period SF5).

For example, detailed description of the timing of the bias scan signal EB, the write scan signal GW, the common emission control signal EM0, the first emission control signal EM1, the second emission control signal EM2, the third emission control signal EM3, the fourth emission control signal EM4, and the fifth emission control signal EM5 in each frame period FRM is provided below.

During the frame period FRM, the bias scan signal EB may have an active level in the initialization period P1 of each sub-frame period (e.g., each of the first to fifth sub-periods SF1 to SF5).

During the frame period FRM, the write scan signal GW may have an active level in the initialization period P1 of each sub-frame period (e.g., each of the first to fifth sub-periods SF1 to SF5) and the data writing period P3 of each sub-frame period (e.g., each of the first to fifth sub-periods SF1 to SF5).

During the frame period FRM, the common emission control signal EM0 may have an active level in the initialization period P1 of each sub-frame period (e.g., each of the first to fifth sub-periods SF1 to SF5) and the emission period P4 of each sub-frame period (e.g., each of the first to fifth sub-periods SF1 to SF5).

During the frame period FRM, the first emission control signal EM1 may have an active level in the initialization period P1 of the first sub-frame period SF1 and the emission period P4 of the first sub-frame period SF1.

During the frame period FRM, the second emission control signal EM2 may have an active level in the initialization period P1 of the second sub-frame period SF2 and the emission period P4 of the second sub-frame period SF2.

During the frame period FRM, the third emission control signal EM3 may have an active level in the initialization period P1 of the third sub-frame period SF3 and the emission period P4 of the third sub-frame period SF3.

During the frame period FRM, the fourth emission control signal EM4 may have an active level in the initialization period P1 of the fourth sub-frame period SF4 and the emission period P4 of the fourth sub-frame period SF4.

During the frame period FRM, the fifth emission control signal EM5 may have an active level in the initialization period P1 of the fifth sub-frame period SF5 and the emission period P4 of the fifth sub-frame period SF5.

Each of the reference voltage Vref, the driving voltage ELVDD, the common voltage ELVSS, and the ground voltage VGR described above may be a direct current voltage. The reference voltage Vref may be smaller than the driving voltage ELVDD and larger than the common voltage ELVSS. The driving voltage ELVDD may be the same as (or similar to) the above-described second driving voltage VDD, and the common voltage ELVSS may be the same as (or similar to) the above-described first driving voltage VSS.

Hereinafter, with reference to FIGS. 9 and 10, detailed description of the operation of the display device is provided below. For example, since the operation of the display device in each of the sub-frame periods SF1 to SF5 is substantially the same or similar to each other, the operation of the display device in the initialization period P1, the threshold voltage detection period P2, the data writing period P3 and the emission period P4 of the first sub-frame period SF1 is provided below, and detailed description of the same or similar constituent elements is omitted.

With reference to FIGS. 9 and 10, detailed description of the operation of the display device 10 in the initialization period P1 of the first sub-frame period SF1 is provided below.

In the initialization period P1 (e.g., the initialization period P1 of the first sub-frame period SF1), the bias scan signal EB of an active level may be applied to the gate electrode of the initialization transistor Ti through the bias scan line EBL. Accordingly, in the initialization period P1, the initialization transistor Ti may be turned on.

In the initialization period P1, the write scan signal GW of an active level may be applied to the gate electrode of the switching transistor Ts through the write scan line GWL. Accordingly, in the initialization period P1, the switching transistor Ts may be turned on.

In the initialization period P1, the common emission control signal EM0 of an active level may be applied to the gate electrode of the common emission control transistor Te0 through the common emission control line EML0. Accordingly, in the initialization period P1, the common emission control transistor Te0 may be turned on.

In the initialization period P1, the first emission control signal EM1 of an active level may be applied to the gate electrode of the first emission control transistor Te1 through the first emission control line EML1. Accordingly, in the initialization period P1, the first emission control transistor Te1 may be turned on.

In the initialization period P1, the second emission control signal EM2 of a non-active level may be applied to the gate electrode of the second emission control transistor Te2 through the second emission control line EML2. Accordingly, in the initialization period P1, the second emission control transistor Te2 may be turned off.

In the initialization period P1, the third emission control signal EM3 of a non-active level may be applied to the gate electrode of the third emission control transistor Te3 through the third emission control line EML3. Accordingly, in the initialization period P1, the third emission control transistor Te3 may be turned off.

In the initialization period P1, the fourth emission control signal EM4 of a non-active level may be applied to the gate electrode of the fourth emission control transistor Te4 through the fourth emission control line EML4. Accordingly, in the initialization period P1, the fourth emission control transistor Te4 may be turned off.

In the initialization period P1, the fifth emission control signal EM5 of a non-active level may be applied to the gate electrode of the fifth emission control transistor Te5 through the fifth emission control line EML5. Accordingly, in the initialization period P1, the fifth emission control transistor Te5 may be turned off.

In the initialization period P1, the reference voltage Vref from the data line DL may be applied to the gate electrode of the driving transistor Td through the turned-on switching transistor Ts, the driving voltage ELVDD from the driving voltage line VDL may be applied to the source electrode of the driving transistor Td through the turned-on common emission control transistor Te0, and the ground voltage VGR from the ground GND may be applied to the drain electrode of the driving transistor Td through the turned-on initialization transistor Ti. Accordingly, the voltages of the gate electrode, the source electrode, and the drain electrode of the driving transistor Td may be initialized, respectively. For example, the voltages of the gate electrode of the driving transistor Td may be initialized to the reference voltage Vref, the voltage of the source electrode of the driving transistor Td may be initialized to the driving voltage ELVDD, and the drain electrode of the driving transistor Td may be initialized to the ground voltage VGR.

In the initialization period P1, the ground voltage VGR from the ground GND may be applied to the anode electrode of the light emitting element through the turned-on initialization transistor Ti and the turned-on first emission control transistor Te1. Accordingly, the voltage of the anode electrode of the first light emitting element LE1 may be initialized. For example, the voltage of the anode electrode may be initialized to the ground voltage VGR. For example, the voltage of the cathode electrode of the light emitting element may be initialized to the common voltage ELVSS.

As described above, in the initialization period P1, the voltages of the gate electrode, the source electrode, and the drain electrode of the driving transistor Td may be initialized, and the voltages of the anode electrode and the cathode electrode of the light emitting element may be initialized.

For example, in the initialization period P1 (e.g., the initialization period P1 of the first sub-frame period SF1), the driving transistor Td may be turned on by the reference voltage Vref applied to the first node N1 and a driving voltage VDD of the second node N2.

With reference to FIGS. 9 and 10, detailed description of the operation of the display device 10 in the threshold voltage detection period P2 of the first sub-frame period SF1 is provided below.

In the threshold voltage detection period P2 (e.g., the threshold voltage detection period P2 of the first sub-frame period SF1), the common emission control signal EM0 of a non-active level may be applied to the gate electrode of the common emission control transistor Te0 through the common emission control line EML0. Accordingly, in the threshold voltage detection period P2, the common emission control transistor Te0 may be turned off.

In the threshold voltage detection period P2, the bias scan signal EB of a non-active level may be applied to the gate electrode of the initialization transistor Ti through the bias scan line EBL. Accordingly, in the threshold voltage detection period P2, the initialization transistor Ti may be turned off.

In the threshold voltage detection period P2, the write scan signal GW of a non-active level may be applied to the gate electrode of the switching transistor Ts through the write scan line GWL. Accordingly, in the threshold voltage detection period P2, the switching transistor Ts may be turned off.

In the threshold voltage detection period P2, the first emission control signal EM1 of a non-active level may be applied to the gate electrode of the first emission control transistor Te1 through the first emission control line EML1. Accordingly, in the threshold voltage detection period P2, the first emission control transistor Te1 may be turned off.

In the threshold voltage detection period P2, the second emission control signal EM2 of a non-active level may be applied to the gate electrode of the second emission control transistor Te2 through the second emission control line EML2. Accordingly, in the threshold voltage detection period P2, the second emission control transistor Te2 may be turned off.

In the threshold voltage detection period P2, the third emission control signal EM3 of a non-active level may be applied to the gate electrode of the third emission control transistor Te3 through the third emission control line EML3. Accordingly, in the threshold voltage detection period P2, the third emission control transistor Te3 may be turned off.

In the threshold voltage detection period P2, the fourth emission control signal EM4 of a non-active level may be applied to the gate electrode of the fourth emission control transistor Te4 through the fourth emission control line EML4. Accordingly, in the threshold voltage detection period P2, the fourth emission control transistor Te4 may be turned off.

In the threshold voltage detection period P2, the fifth emission control signal EM5 of a non-active level may be applied to the gate electrode of the fifth emission control transistor Te5 through the fifth emission control line EML5. Accordingly, in the threshold voltage detection period P2, the fifth emission control transistor Te5 may be turned-off.

In the threshold voltage detection period P2, in case that the switching transistor Ts is turned off, the first node N1 may maintain a floating state.

In the threshold voltage detection period P2, the driving transistor Td may maintain a turned-on state by the reference voltage Vref applied to the first node N1 in the previous period (e.g., initialization period P1) and the driving voltage VDD of the second node N2.

For example, in the threshold voltage detection period P2 (e.g., the threshold voltage detection period P2 of the first sub-frame period SF1), the voltage of the second node N2 may gradually decrease due to the current flowing through the turned-on driving transistor Td. For example, in case that the common emission control transistor Te0 is turned off, the supply of the driving voltage ELVDD to the second node N2 may be stopped. Thus, the charge of the second node N2 may flow to the third node N3 through the turned-on driving transistor Td, and the voltage of the second node N2 may gradually decrease. Accordingly, the gate-source voltage of the driving transistor Td may gradually decrease. When the gate-source voltage reaches the threshold voltage of the driving transistor Td, the threshold voltage of the driving transistor Td may be turned off, the threshold voltage of the driving transistor Td may be detected using a source follower method, and the detected threshold voltage of the driving transistor Td may be applied to (or reflected in) the first node N1. For example, the charge of the third node N3 may be emitted through a parasitic capacitor electrically connected to the third node N3.

During the threshold voltage detection period P2 (e.g., the threshold voltage detection period P2 of the first sub-frame period SF1), the threshold voltage of the driving transistor Td may be detected and maintained by the first capacitor C1.

With reference to FIGS. 9 and 10, detailed description of the operation of the display device 10 (e.g., refer to FIG. 1) in the data writing period P3 of the first sub-frame period SF1 is provided below.

In the data writing period P3 (e.g., the data writing period P3 of the first sub-frame period SF1), the write scan signal GW of an active level may be applied to the gate electrode of the switching transistor Ts through the write scan line GWL. Accordingly, the switching transistor Ts may be turned on.

In the data writing period P3, the bias scan signal EB of a non-active level may be applied to the gate electrode of the initialization transistor Ti through the bias scan line EBL. Accordingly, in the data writing period P3, the initialization transistor Ti may be turned off.

In the data writing period P3, the common emission control signal EM0 of a non-active level may be applied to the gate electrode of the common emission control transistor Te0 through the common emission control line EML0. Accordingly, in the data writing period P3, the common emission control transistor Te0 may be turned off.

In the data writing period P3, the first emission control signal EM1 of a non-active level may be applied to the gate electrode of the first emission control transistor Te1 through the first emission control line EML1. Accordingly, in the data writing period P3, the first emission control transistor Te1 may be turned off.

In the data writing period P3, the second emission control signal EM2 of a non-active level may be applied to the gate electrode of the second emission control transistor Te2 through the second emission control line EML2. Accordingly, in the data writing period P3, the second emission control transistor Te2 may be turned off.

In the data writing period P3, the third emission control signal EM3 of a non-active level may be applied to the gate electrode of the third emission control transistor Te3 through the third emission control line EML3. Accordingly, in the data writing period P3, the third emission control transistor Te3 may be turned off.

In the data writing period P3, the fourth emission control signal EM4 of a non-active level may be applied to the gate electrode of the fourth emission control transistor Te4 through the fourth emission control line EML4. Accordingly, in the data writing period P3, the fourth emission control transistor Te4 may be turned off.

In the data writing period P3, the fifth emission control signal EM5 of a non-active level may be applied to the gate electrode of the fifth emission control transistor Te5 through the fifth emission control line EML5. Accordingly, in the data writing period P3, the fifth emission control transistor Te5 may be turned off.

In the data writing period P3 (e.g., the data writing period P3 of the first sub-frame period SF1), the first data voltage Vdt1 from the data line DL may be applied to the first node N1 through the turned-on switching transistor Ts.

For example, a second data voltage Vdt2 may be applied to the data line DL in the data writing period P3 of the second sub-frame period SF2, a third data voltage Vdt3 may be applied to the data line DL in the data writing period P3 of the third sub-frame period SF3, a fourth data voltage Vdt4 may be applied to the data line DL in the data writing period P3 of the fourth sub-frame period SF4, and a fifth data voltage Vdt5 may be applied to the data line DL in the data writing period P3 of the fifth sub-frame period SF5.

The first data voltage Vdt1 may be the data voltage of the first pixel PX1, the second data voltage Vdt2 may be the data voltage of the second pixel PX2, the third data voltage Vdt3 may be the data voltage of the third pixel PX3, the fourth data voltage Vdt4 may be the data voltage of the fourth pixel PX4, and the fifth data voltage Vdt5 may be the data voltage of the fifth pixel PX5.

The first data voltage Vdt1, the second data voltage Vdt2, the third data voltage Vdt3, the fourth data voltage Vdt4, and the fifth data voltage Vdt5 may be applied to a data line DL in a time-division manner, and accordingly, the first to fifth data voltages Vdt1 to Vdt5 may be sequentially provided to the first to fifth pixels PX1 to PX5, respectively, through the data line DL. The first data voltage Vdt1, the second data voltage Vdt2, the third data voltage Vdt3, the fourth data voltage Vdt4, and the fifth data voltage Vdt5 may be provided from the data driver 700 to the data line DL.

With reference to FIGS. 9 and 10, detailed description of the operation of the display device 10 in the emission period P4 of the first sub-frame period SF1 is provided below.

In the emission period P4 (e.g., the emission period P4 of the first sub-frame period SF1), the common emission control signal EM0 of an active level may be applied to the gate electrode of the common emission control transistor Te0 through the common emission control line EML0. Accordingly, in the emission period P4, the common emission control transistor Te0 may be turned on.

In the emission period P4, the first emission control signal EM1 of an active level may be applied to the gate electrode of the first emission control transistor Te1 through the first emission control line EML1. Accordingly, in the emission period P4, the first emission control transistor Te1 may be turned on.

In the emission period P4, the bias scan signal EB of a non-active level may be applied to the gate electrode of the initialization transistor Ti through the bias scan line EBL. Accordingly, in the emission period P4, the initialization transistor Ti may be turned off.

In the emission period P4, the write scan signal GW of a non-active level may be applied to the gate electrode of the switching transistor Ts through the write scan line GWL. Accordingly, in the emission period P4, the switching transistor Ts may be turned off.

In the emission period P4, the second emission control signal EM2 of a non-active level may be applied to the gate electrode of the second emission control transistor Te2 through the second emission control line EML2. Accordingly, in the emission period P4, the second emission control transistor Te2 may be turned off.

In the emission period P4, the third emission control signal EM3 of a non-active level may be applied to the gate electrode of the third emission control transistor Te3 through the third emission control line EML3. Accordingly, in the emission period P4, the third emission control transistor Te3 may be turned off.

In the emission period P4, the fourth emission control signal EM4 of a non-active level may be applied to the gate electrode of the fourth emission control transistor Te4 through the fourth emission control line EML4. Accordingly, in the emission period P4, the fourth emission control transistor Te4 may be turned off.

In the emission period P4, the fifth emission control signal EM5 of a non-active level may be applied to the gate electrode of the fifth emission control transistor Te5 through the fifth emission control line EML5. Accordingly, in the emission period P4, the fifth emission control transistor Te5 may be turned off.

In the emission period P4, the driving transistor Td may maintain a turned-on state by the gate-source voltage maintained by the first capacitor C1. The gate-source voltage may include a threshold voltage of the driving transistor Td and the first data voltage Vdt1.

In the emission period P4 (e.g., the emission period P4 of the first sub-frame period SF1), in case that each of the common emission control transistor Te0, the driving transistor Td, and the first emission control transistor Te1 is turned on, a driving current Isd may be supplied to the first light emitting element LE1 from the driving voltage line VDL. Accordingly, the first light emitting element LE1 may emit light by the driving current Isd. The gate-source voltage maintained by the first capacitor C1 may include the threshold voltage of the driving transistor Td, and the magnitude of the driving current Isd flowing to the first light emitting element LE1 through the turned-on driving transistor Td may be determined based on the first data voltage Vdt1 and the threshold voltage of the driving transistor Td. Accordingly, the driving current Isd supplied to the first light emitting element LE1 may accurately reflect (e.g., be accurately proportional to) the magnitude of the first data voltage Vdt1. For example, the driving current Isd described above may have an accurate value at which the threshold voltage of the driving transistor Td is compensated.

For example, in the emission period P4 of the second sub-frame period SF2, the common emission control transistor Te0, the driving transistor Td, and the second emission control transistor Te2 may be turned on, and the second light emitting element LE2 may emit light. In the emission period P4 of the third sub-frame period SF3, the common emission control transistor Te0, the driving transistor Td, and the third emission control transistor Te3 may be turned on, and the third light emitting element LE3 may emit light. In the emission period P4 of the fourth sub-frame period SF4, the common emission control transistor Te0, the driving transistor Td, and the fourth emission control transistor Te4 may be turned on, and the fourth light emitting element LE4 may emit light. In the emission period P4 of the fifth sub-frame period SF5, the common emission control transistor Te0, the driving transistor Td, and the fifth emission control transistor Te5 may be turned, and the fifth light emitting element LE5 may emit light.

In case that the first light emitting element LE1 emits light in the emission period P4 of the first sub-frame period SF1, the remaining light emitting elements except the first light emitting element LE1 (e.g., the second to fifth light emitting elements LE2 to LE5) may be turned off. In case that the second light emitting element LE2 emits light in the emission period P4 of the second sub-frame period SF2, the remaining light emitting elements except the second light emitting element LE2 (e.g., the first, third, fourth, and fifth light emitting elements LE1, LE3, LE4, and LE5) may be turned off. In case that the third light emitting element LE3 emits light in the emission period P4 of the third sub-frame period SF3, the remaining light emitting elements except the third light emitting element LE3 (e.g., the first, second, fourth, and fifth light emitting elements LE1, LE2, LE4, and LE5) may be turned off. In case that the fourth light emitting element LE4 emits light in the emission period P4 of the fourth sub-frame period SF4, the remaining light emitting elements except the fourth light emitting element LE4 (e.g., the first, second, third, and fifth light emitting elements LE1, LE2, LE3, and LE5) may be turned off. In case that the fifth light emitting element LE5 emits light in the emission period P4 of the fifth sub-frame period SF5, the remaining light emitting elements except the fifth light emitting element LE5 (e.g., the first to fourth light emitting elements LE1 to LE4) may be turned off. Accordingly, the light-emitting state may be maintained for about 20% of each frame period FRM. For example, the display device according to an embodiment may emit light with a duty ratio of about 20%.

In a micro display device, the display device may emit light at a luminance level of about 10% to 20% during each frame period FRM and prevent screen drag, user dizziness, and motion sickness. Thus, the display device according to an embodiment may solve the issues as described above and secure a large idle area where the driving circuits of the display device can be placed. For example, since the second to fifth pixels PX2 to PX5 substantially include the second to fifth light emitting elements LE2 to LE5, respectively, the first pixel PX1 may include a common pixel circuit PC for driving the first light emitting element LE1, the second light emitting element LE2, the third light emitting element LE3, the fourth light emitting element LE4, and the fifth light emitting element LE5, and the second to fifth pixels PX2 to PX5 may include a large area (i.e., idle area or unused area) that is not occupied by the pixel circuit PC.

Driving circuits of the display device 10 may be disposed in the above-described idle area. For example, at least one of the power supply circuit 500, the scan driver 610, the emission driver 620, and the data driver 700 of FIG. 2 may be disposed in the idle area. Accordingly, the display device 10 according to an embodiment may be manufactured with high integration.

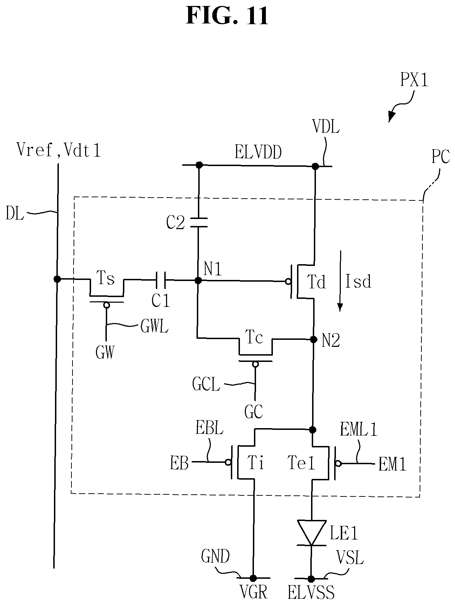

FIG. 11 is a schematic diagram of an equivalent circuit illustrating a first pixel PX1 according to an embodiment.

As illustrated in FIG. 11, the first pixel PX1 may include a driving transistor Td, a switching transistor Ts, a compensation transistor Tc, a first emission control transistor Te1, an initialization transistor Ti, a first capacitor C1, a second capacitor C2, and a first light emitting element LE1.

The first pixel PX1 of FIG. 11 may be substantially the same as or similar to the first pixel PX1 of FIG. 8 described above. The first pixel PX1 of FIG. 11 is different from the first pixel PX1 of FIG. 8 at least in that the drain electrode of the initialization transistor Ti is electrically connected to a ground GND, and detailed description of the difference is provided below.

The initialization transistor Ti of FIG. 11 may be turned on by a bias scan signal EB from a bias scan line EBL and electrically connect the anode electrode of a first light emitting element LE1 and the ground GND. The gate electrode of the initialization transistor Ti may be electrically connected to the bias scan line EBL, the source electrode of the initialization transistor Ti may be electrically connected to the anode electrode of the first light emitting element LE1, and the drain electrode of the initialization transistor Ti may be electrically connected to the ground GND.

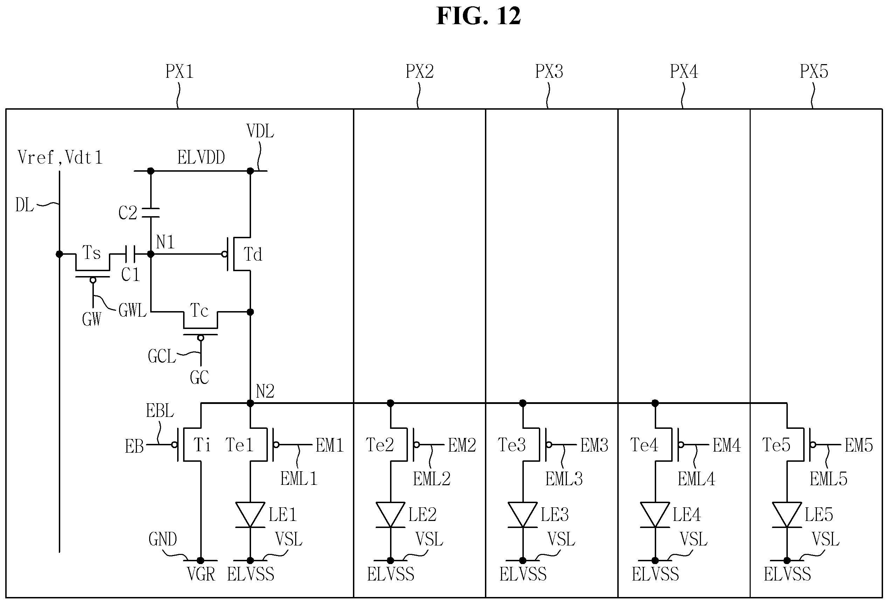

FIG. 12 is a schematic diagram of an equivalent circuit illustrating second, third, fourth, and fifth pixels PX2 to PX5 electrically connected to the first pixel PX1 of FIG. 11.

In case that the first pixel PX1 is defined as the main pixel and the second to fifth pixels PX2 to PX5 electrically connected to the first pixel PX1 are each defined as the sub-pixel, the main pixel and the sub-pixel may have different configurations. For example, the main pixel (e.g., the first pixel PX1) may include a driving transistor Td, a switching transistor Ts, a compensation transistor Tc, a first emission control transistor Te1, an initialization transistor Ti, a first capacitor C1, a second capacitor C2, and a first light emitting element LE1, and the sub-pixel (e.g., the second to fifth pixels PX2 to PX5) may include an emission control transistor (e.g., second to fifth emission control transistors Te2 to Te5) and a light emitting element (e.g., second to fifth light emitting elements LE2 to LE5). Detailed description of the configuration of the sub-pixels (e.g., second pixel PX2, third pixel PX3, fourth pixel PX4, and fifth pixel PX5) is provided below.

The second pixel PX2 may include a second emission control transistor Te2 and a second light emitting element LE2.

The second emission control transistor Te2 may be turned on by a second emission control signal EM2 from a second emission control line EML2 and electrically connect the second node N2 and the anode electrode of the second light emitting element LE2. The gate electrode of the second emission control transistor Te2 may be electrically connected to the second emission control line EML2, the source electrode of the second emission control transistor Te2 may be electrically connected to the second node N2, and the drain electrode of the second emission control transistor Te2 may be electrically connected to the anode electrode of the second light emitting element LE2.

The third pixel PX3 may include a third emission control transistor Te3 and a third light emitting element LE3.

The third emission control transistor Te3 may be turned on by a third emission control signal EM3 from a third emission control line EML3 and electrically connect the second node N2 and the anode electrode of the third light emitting element LE3. The gate electrode of the third emission control transistor Te3 may be electrically connected to the third emission control line EML3, the source electrode of the third emission control transistor Te3 may be electrically connected to the second node N2, and the drain electrode of the third emission control transistor Te3 may be electrically connected to the anode electrode of the third light emitting element LE3.

The fourth pixel PX4 may include a fourth emission control transistor Te4 and a fourth light emitting element LE4.

The fourth emission control transistor Te4 may be turned on by a fourth emission control signal EM4 from a fourth emission control line EML4 and electrically connect the second node N2 and the anode electrode of the fourth light emitting element LE4. The gate electrode of the fourth emission control transistor Te4 may be electrically connected to the fourth emission control line EML4, the source electrode of the fourth emission control transistor Te4 may be electrically connected to the second node N2, and the drain electrode of the fourth emission control transistor Te4 may be electrically connected to the anode electrode of the fourth light emitting element LE4.

The fifth pixel PX5 may include a fifth emission control transistor Te5 and a fifth light emitting element LE5.

The fifth emission control transistor Te5 may be turned on by a fifth emission control signal EM5 from a fifth emission control line EML5 and electrically connect the second node N2 and the anode electrode of the fifth light emitting element LE5. The gate electrode of the fifth emission control transistor Te5 may be electrically connected to the fifth emission control line EML5, the source electrode of the fifth emission control transistor Te5 may be electrically connected to the second node N2, and the drain electrode of the fifth emission control transistor Te5 may be electrically connected to the anode electrode of the fifth light emitting element LE5.

The number of the sub-pixels (e.g., the second to fifth sub-pixels PX2 to PX5) electrically connected to a main pixel (e.g., the first pixel PX1) may vary. For example, the number of the sub-pixels electrically connected to the main pixel may be less than four. In other embodiments, the number of the sub-pixels electrically connected to the main pixel be more than four.

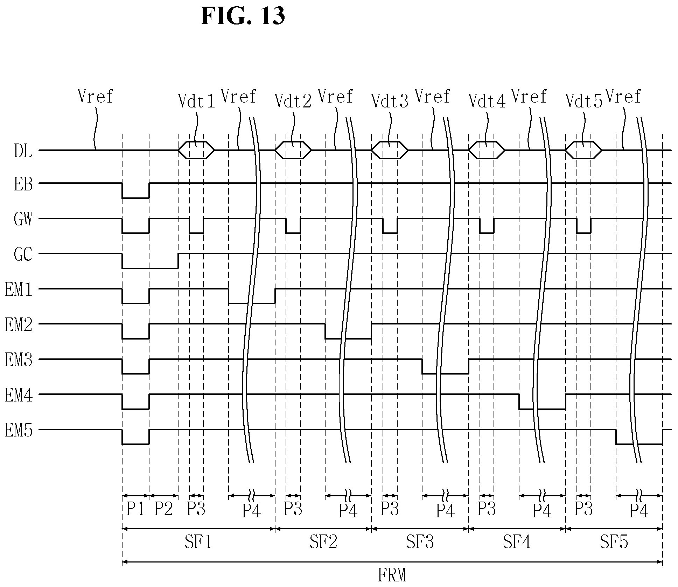

FIG. 13 is a schematic diagram illustrating an embodiment in respect to a timing diagram of a reference voltage Vref, data voltages Vdt1 to Vdt5, a bias scan signal EB, a write scan signal GW, a compensation scan signal GC, a first emission control signal EM1, a second emission control signal EM2, a third emission control signal EM3, a fourth emission control signal EM4, and a fifth emission control signal EM5 of FIG. 11.

Referring to FIGS. 12 and 13, the first pixel PX1, the second pixel PX2, the third pixel PX3, the fourth pixel PX4, and the fifth pixel PX5 may sequentially emit light during a frame period FRM. For example, the first pixel PX1, the second pixel PX2, the third pixel PX3, the fourth pixel PX4, and the fifth pixel PX5 may sequentially emit light in a time-division manner during each frame period FRM. Since the time-division driving method in respect to the first to fifth pixels PX1 to PX5 of FIG. 11 is the same as or similar to the time-division driving method in respect to the first to fifth pixels PX1 to PX5 of FIG. 9 described above, detailed description of the same or similar constituent elements is omitted.

According to an embodiment, each frame period FRM may include a first sub-frame period SF1, a second sub-frame period SF2, a third sub-frame period SF3, a fourth sub-frame period SF4, a fourth sub-frame period SF4, and a fifth sub-frame period SF5. The first pixel PX1 may emit light during the first sub-frame period SF1, the second pixel PX2 may emit light during the second sub-frame period SF2, the third pixel PX3 may emit light during the third sub-frame period SF3, the fourth pixel PX4 may emit light during the fourth sub-frame period SF4, and the fifth pixel PX5 may emit light during the fifth sub-frame period SF5.

According to an embodiment, in case that each pixel emits light during each sub-frame period, the remaining pixels may be maintained in a non-emission state.

According to an embodiment, the sub-frame period may include an initialization period P1, a threshold voltage detection period P2, a data writing period P3, and an emission period P4. For example, the first sub-frame period SF1, which is an initial sub-frame period (or starts temporally first) among the first to fifth sub-frame periods SF1 to SF5 of each frame period FRM, may include the initialization period P1, the threshold voltage detection period P2, the data writing period P3, and the emission period P4.

According to an embodiment, another sub-frame period (e.g., the second to fifth sub-frame periods SF2 to SF5) may include a data writing period P3 and an emission period P4, and may not include the initialization period P1 or the threshold voltage detection period P2. For example, each of the second to fifth sub-frame periods SF2 to SF5 except the first sub-frame period SF1 described above may include the data writing period P3 and the emission period P4.

Each of the bias scan signal EB, the write scan signal GW, the compensation scan signal GC, the first emission control signal EM1, the second emission control signal EM2, the third emission control signal EM3, the fourth emission control signal EM4, and the fifth emission control signal EM5 may have an active level or a non-active level for each of the periods P1, P2, P3, and P4. The active level of each of the signals EB, GW, GC, EM1, EM2, EM3, EM4, and EM5 may mean a voltage at a level capable of turning on the corresponding transistor to which the signal is applied. For example, the signal of the active level may have a value greater than the threshold voltage of the corresponding transistor. For example, as illustrated in FIG. 12, in case that each of the transistors Td, Ts, Tc, Te1, Te2, Te3, Te4, Te5, and Ti is a P-type transistor, the active level of each of the signals EB, GW, GC, EM1, EM2, EM3, EM4, and EM5 may mean a low level (e.g., negative polarity level or low voltage level).

For example, the non-active level of each of the signals EB, GW, GC, EM1, EM2, EM3, EM4, and EM5 may mean a voltage at a level capable of turning off the corresponding transistor. For example, the signal of the non-active level may have a value smaller than the threshold voltage of the corresponding transistor. For example, as illustrated in FIG. 12, in case that each of the transistors Td, Ts, Tc, Te1, Te2, Te3, Te4, Te5, and Ti is a P-type transistor, the non-active level of each of the signals EB, GW, GC, EM1, EM2, EM3, EM4, and EM5 may mean a high level (e.g., positive polarity level or high voltage level).

In other embodiments, in case that each of the transistors Td, Ts, Tc, Te1, Te2, Te3, Te4, Te5, and Ti is an N-type transistor, the active level of each of the signals EB, GW, GC, EM1, EM2, EM3, EM4, and EM5 may mean the high level (e.g., positive polarity level or high voltage level), and the non-active level of each of the signals EB, GW, GC, EM1, EM2, EM3, EM4, and EM5 may mean the low level (e.g., negative polarity level or low voltage level).

In the initialization period P1 of the first sub-frame period SF1, each of the bias scan signal EB, the write scan signal GW, the compensation scan signal GC, the first emission control signal EM1, the second emission control signal EM2, the third emission control signal EM3, the fourth emission control signal EM4, and the fifth emission control signal EM5 may have an active level. In the initialization period P1 of the first sub-frame period SF1, the reference voltage Vref may be applied to the data line DL.

In the threshold voltage detection period P2 of the first sub-frame period SF1, the compensation scan signal GC (e.g., the compensation scan signal GC of an active level) may have an active level, and each of the bias scan signal EB, the write scan signal GW, the first emission control signal EM1, the second emission control signal EM2, the third emission control signal EM3, the fourth emission control signal EM4, and the fifth emission control signal EM5 may have a non-active level. In the threshold voltage detection period P2 of the first sub-frame period SF1, the reference voltage Vref may be applied to the data line DL.

In the data writing period P3 of the first sub-frame period SF1, the write scan signal GW may have an active level, and each of the bias scan signal EB, the compensation scan signal GC, the first emission control signal EM1, the second emission control signal EM2, the third emission control signal EM3, the fourth emission control signal EM4, and the fifth emission control signal EM5 may have a non-active level. In the data writing period P3 of the first sub-frame period SF1, the first data voltage Vdt1 may be applied to the data line DL.

In the emission period P4 of the first sub-frame period SF1, the first emission control signal EM1 may have an active level, and each of the bias scan signal EB, the write scan signal GW, the compensation scan signal GC, the second emission control signal EM2, the third emission control signal EM3, the fourth emission control signal EM4, and the fifth emission control signal EM5 may have a non-active level. In the emission period P4 of the first sub-frame period SF1, the reference voltage Vref may be applied to the data line DL.

For example, detailed description of the timing of the bias scan signal EB, the write scan signal GW, the compensation scan signal GC, the first emission control signal EM1, the second emission control signal EM2, the third emission control signal EM3, the fourth emission control signal EM4, and the fifth emission control signal EM5 in each frame period FRM is provided below.

During the frame period FRM, the bias scan signal EB may have an active level in the initialization period P1 of the first sub-frame period SF1.

During the frame period FRM, the write scan signal GW may have an active level in each of the initialization period P1 of the first sub-frame period SF1, the data writing period P3 of the first sub-frame period SF1, and the data writing period P3 of other sub-frame periods. Other sub-frame periods may mean, for example, the remaining sub-frame periods (e.g., second to fifth sub-frame periods SF2 to SF5) except the first sub-frame period SF1.

During the frame period FRM, the compensation scan signal GC may have an active level in each of the initialization period P1 of the first sub-frame period SF1 and the threshold voltage detection period P2 of the first sub-frame period SF1.

During the frame period FRM, the first emission control signal EM1 may have an active level in each of the initialization period P1 of the first sub-frame period SF1 and the emission period P4 of the first sub-frame period SF1.

During the frame period FRM, the second emission control signal EM2 may have an active level in each of the initialization period P1 of the first sub-frame period SF1 and the emission period P4 of the second sub-frame period SF2.

During the frame period FRM, the third emission control signal EM3 may have an active level in each of the initialization period P1 of the first sub-frame period SF1 and the emission period P4 of the third sub-frame period SF3.

During the frame period FRM, the fourth emission control signal EM4 may have an active level in each of the initialization period P1 of the first sub-frame period SF1 and the emission period P4 of the fourth sub-frame period SF4.

During the frame period FRM, the fifth emission control signal EM5 may have an active level in each of the initialization period P1 of the first sub-frame period SF1 and the emission period P4 of the fifth sub-frame period SF5.

Hereinafter, with reference to FIGS. 12 and 13, detailed description of the operations of the display device 10 is provided below. For example, since the operation of the display device 10 in each of the sub-frame periods SF1 to SF5 are substantially the same or similar to each other, the operations in the initialization period P1, the threshold voltage detection period P2, the data writing period P3, and the emission period P4 of the first sub-frame period SF1 is provided below, and detailed description of the same or similar constituent elements is omitted.

With reference to FIGS. 12 and 13, detailed description of the operation of the display device 10 in the initialization period P1 of the first sub-frame period SF1 is provided below.

In the initialization period P1 (e.g., the initialization period P1 of the first sub-frame period SF1), the bias scan signal EB of an active level may be applied to the gate electrode of the initialization transistor Ti through the bias scan line EBL. Accordingly, in the initialization period P1, the initialization transistor Ti may be turned on.

In the initialization period P1, the write scan signal GW of an active level may be applied to the gate electrode of the switching transistor Ts through the write scan line GWL. Accordingly, in the initialization period P1, the switching transistor Ts may be turned on.

In the initialization period P1, the compensation scan signal GC (e.g., the compensation scan signal GC of an active level) may be applied to the gate electrode of the compensation transistor Tc through the compensation scan line GCL. Accordingly, in the initialization period P1, the compensation transistor Tc may be turned on.

In the initialization period P1, the first emission control signal EM1 of an active level may be applied to the gate electrode of the first emission control transistor Te1 through the first emission control line EML1. Accordingly, in the initialization period P1, the first emission control transistor Te1 may be turned on.

In the initialization period P1, the second emission control signal EM2 of an active level may be applied to the gate electrode of the second emission control transistor Te2 through the second emission control line EML2. Accordingly, in the initialization period P1, the second emission control transistor Te2 may be turned on.

In the initialization period P1, the third emission control signal EM3 of an active level may be applied to the gate electrode of the third emission control transistor Te3 through the third emission control line EML3. Accordingly, in the initialization period P1, the third emission control transistor Te3 may be turned on.

In the initialization period P1, the fourth emission control signal EM4 of an active level may be applied to the gate electrode of the fourth emission control transistor Te4 through the fourth emission control line EML4. Accordingly, in the initialization period P1, the fourth emission control transistor Te4 may be turned on.

In the initialization period P1, the fifth emission control signal EM5 of an active level may be applied to the gate electrode of the fifth emission control transistor Te5 through the fifth emission control line EML5. Accordingly, in the initialization period P1, the fifth emission control transistor Te5 may be turned on.

In the initialization period P1, the reference voltage Vref from the data line DL may be applied to the gate electrode of the driving transistor Td through the turned-on switching transistor Ts and the first capacitor C1, the driving voltage ELVDD from the driving voltage line VDL may be applied to the source electrode of the driving transistor Td, and the ground voltage VGR from the ground GND may be applied to the drain electrode of the driving transistor Td through the turned-on initialization transistor Ti. Accordingly, the voltages of the gate electrode, the source electrode, and the drain electrode of the driving transistor Td may be initialized, respectively. For example, the voltages of the gate electrode of the driving transistor Td may be initialized to the reference voltage Vref, the voltage of the source electrode of the driving transistor Td may be initialized to the driving voltage ELVDD, and the drain electrode of the driving transistor Td may be initialized to the ground voltage VGR.

In the initialization period P1, the ground voltage VGR from the ground GND may be applied to the anode electrode of the light emitting element (e.g., the first light emitting element LE1) through the turned-on initialization transistor Ti and the turned-on first emission control transistor Te1. Accordingly, the voltage of the anode electrode of the first light emitting element LE1 may be initialized. For example, the voltage of the anode electrode of the first light emitting element LE1 may be initialized to the ground voltage VGR. For example, the voltage of the cathode electrode of the first light emitting element LE1 may be initialized to the common voltage ELVSS.

As described above, in the initialization period P1, the voltages of the gate electrode, the source electrode, and the drain electrode of the driving transistor Td may be initialized, and the voltages of the anode electrode and the cathode electrode of the first light emitting element LE1 may be initialized.

For example, in the initialization period P1, the driving transistor Td may maintain a turned-on state by the reference voltage Vref applied to the first node N1 and the driving voltage ELVDD of the source electrode of the driving transistor Td.

With reference to FIGS. 12 and 13, detailed description of the operation of the display device 10 in the threshold voltage detection period P2 of the first sub-frame period SF1 is provided below.

In the threshold voltage detection period P2, the compensation scan signal GC of an active level may be applied to the gate electrode of the compensation transistor Tc through the compensation scan line GCL. Accordingly, in the threshold voltage detection period P2, the compensation transistor Tc may be turned on.

In the threshold voltage detection period P2, the bias scan signal EB of a non-active level may be applied to the gate electrode of the initialization transistor Ti through the bias scan line EBL. Accordingly, in the threshold voltage detection period P2, the initialization transistor Ti may be turned off.

In the threshold voltage detection period P2, the write scan signal GW of a non-active level may be applied to the gate electrode of the switching transistor Ts through the write scan line GWL. Accordingly, in the threshold voltage detection period P2, the switching transistor Ts may be turned off.

In the threshold voltage detection period P2, the first emission control signal EM1 of a non-active level may be applied to the gate electrode of the first emission control transistor Te1 through the first emission control line EML1. Accordingly, in the threshold voltage detection period P2, the first emission control transistor Te1 may be turned off.

In the threshold voltage detection period P2, the second emission control signal EM2 of a non-active level may be applied to the gate electrode of the second emission control transistor Te2 through the second emission control line EML2. Accordingly, in the threshold voltage detection period P2, the second emission control transistor Te2 may be turned off.

In the threshold voltage detection period P2, the third emission control signal EM3 of a non-active level may be applied to the gate electrode of the third emission control transistor Te3 through the third emission control line EML3. Accordingly, in the threshold voltage detection period P2, the third emission control transistor Te3 may be turned off.

In the threshold voltage detection period P2, the fourth emission control signal EM4 of a non-active level may be applied to the gate electrode of the fourth emission control transistor Te4 through the fourth emission control line EML4. Accordingly, in the threshold voltage detection period P2, the fourth emission control transistor Te4 may be turned off.

In the threshold voltage detection period P2, the fifth emission control signal EM5 of a non-active level may be applied to the gate electrode of the fifth emission control transistor Te5 through the fifth emission control line EML5. Accordingly, in the threshold voltage detection period P2, the fifth emission control transistor Te5 may be turned-off.

In the threshold voltage detection period P2, the driving transistor Td may maintain a turned-on state by the reference voltage Vref applied to the first node N1 in the previous period (e.g., initialization period P1) and the driving voltage VDD of the source electrode of the driving transistor Td.

For example, in the threshold voltage detection period P2 (e.g., the threshold voltage detection period P2 of the first sub-frame period SF1), in case that the first to fifth emission control transistors Te1 to Te5 electrically connected to the second node N2 and the initialization transistor Ti are turned off, the voltage of the second node N2 may gradually increase due to the current flowing through the turned-on driving transistor Td. For example, the voltage of the second node N2 may gradually increase due to the current flowing through the turned-on driving transistor Td. Since the second node N2 may be electrically connected to the first node N1 through the turned on compensation transistor Tc, the voltage of the first node N1 may increase as the voltage of the second node N2 increases in the threshold voltage detection period P2. As a result, a gate-source voltage of the driving transistor Td may gradually decrease. When the gate-source voltage of the driving transistor Td reaches the threshold voltage of the driving transistor Td, the driving transistor Td may be turned off. In case that the driving transistor Td is turned off, the threshold voltage of the driving transistor Td may be detected, and the detected threshold voltage of the driving transistor Td may be applied to (or reflected in) the first node N1.

With reference to FIGS. 12 and 13, detailed description of the operation of the display device 10 in the emission period P4 of the first sub-frame period SF1 is provided below.

In the emission period P4, the first emission control signal EM1 of an active level may be applied to the gate electrode of the first emission control transistor Te1 through the first emission control line EML1. Accordingly, in the emission period P4, the first emission control transistor Te1 may be turned on.

In the emission period P4, the bias scan signal EB of a non-active level may be applied to the gate electrode of the initialization transistor Ti through the bias scan line EBL. Accordingly, in the emission period P4, the initialization transistor Ti may be turned off.

In the emission period P4, the write scan signal GW of a non-active level may be applied to the gate electrode of the switching transistor Ts through the write scan line GWL. Accordingly, in the emission period P4, the switching transistor Ts may be turned off.

In the emission period P4, the compensation scan signal GC (e.g., the compensation scan signal GC of a non-active level) may be applied to the gate electrode of the compensation transistor Tc through the compensation scan line GCL. Accordingly, in the emission period P4, the compensation transistor Tc may be turned off.

In the emission period P4, the second emission control signal EM2 of a non-active level may be applied to the gate electrode of the second emission control transistor Te2 through the second emission control line EML2. Accordingly, in the emission period P4, the second emission control transistor Te2 may be turned off.

In the emission period P4, the third emission control signal EM3 of a non-active level may be applied to the gate electrode of the third emission control transistor Te3 through the third emission control line EML3. Accordingly, in the emission period P4, the third emission control transistor Te3 may be turned off.

In the emission period P4, the fourth emission control signal EM4 of a non-active level may be applied to the gate electrode of the fourth emission control transistor Te4 through the fourth emission control line EML4. Accordingly, in the emission period P4, the fourth emission control transistor Te4 may be turned off.

In the emission period P4, the fifth emission control signal EM5 of a non-active level may be applied to the gate electrode of the fifth emission control transistor Te5 through the fifth emission control line EML5. Accordingly, in the emission period P4, the fifth emission control transistor Te5 may be turned off.

In the emission period P4, the driving transistor Td may maintain a turned-on state by the gate-source voltage maintained by the first capacitor C1. The gate-source voltage may include a threshold voltage of the driving transistor Td and the first data voltage Vdt1.

In the emission period P4, in case that each of the driving transistor Td and the first emission control transistor Te1 is turned on, a driving current Isd may be supplied to the first light emitting element LE1 from the driving voltage line VDL. Accordingly, the first light emitting element LE1 may emit light by the driving current Isd. The gate-source voltage maintained by the first capacitor C1 may include the threshold voltage of the driving transistor Td, and the magnitude of the driving current Isd flowing to the first light emitting element LE1 through the turned on driving transistor Td may be determined based on the first data voltage Vdt1 and the threshold voltage of the driving transistor Td. Accordingly, the driving current Isd supplied to the first light emitting element LE1 may accurately reflect (e.g., be accurately proportional to) the magnitude of the first data voltage Vdt1. For example, the driving current Isd described above may have an accurate value at which the threshold voltage of the driving transistor Td is compensated.

For example, in the emission period P4 of the second sub-frame period SF2, the driving transistor Td and the second emission control transistor Te2 may be turned on, and the second light emitting element LE2 may emit light. In the emission period P4 of the third sub-frame period SF3, the driving transistor Td and the third emission control transistor Te3 may be turned on, and the third light emitting element LE3 may emit light. In the emission period P4 of the fourth sub-frame period SF4, the driving transistor Td and the fourth emission control transistor Te4 may be turned on, and the fourth light emitting element LE4 may emit light. In the emission period P4 of the fifth sub-frame period SF5, the driving transistor Td and the fifth emission control transistor Te5 may be turned on, and the fifth light emitting element LE5 may emit light.

In case that the first light emitting element LE1 emits light in the emission period P4 of the first sub-frame period SF1, the remaining light emitting elements except the first light emitting element LE1 (e.g., the second to fifth light emitting elements LE2 to LE5) may be turned off. In case that the second light emitting element LE2 emits light in the emission period P4 of the second sub-frame period SF2, the remaining light emitting elements (e.g., the first, third, fourth, and fifth light emitting elements LE1, LE3, LE4, and LE5) except the second light emitting element LE2 may be turned off. In case that the third light emitting element LE3 emits light in the emission period P4 of the third sub-frame period SF3, the remaining light emitting elements (e.g., the first, second, fourth, and fifth light emitting elements LE1, LE2, LE4, and LE5) except the third light emitting element LE3 may be turned off. In case that the fourth light emitting element LE4 emits light in the emission period P4 of the fourth sub-frame period SF4, the remaining light emitting elements (e.g., the first, second, third, and fifth light emitting elements LE1, LE2, LE3, and LE5) except the fourth light emitting element LE4 may be turned off. In case that the fifth light emitting element LE5 emits light in the emission period P4 of the fifth sub-frame period SF5, the remaining light emitting elements (e.g., the first, second, third, fourth light emitting elements LE1, LE2, LE3, and LE4) except the fourth light emitting element LE4 may be turned off. Accordingly, the light-emitting state may be maintained for about 20% of each frame period FRM. For example, the display device 10 according to an embodiment may emit light with a duty ratio of about 20%.

According to an embodiment, in the timing diagram of FIG. 13, at least one among the second to fifth sub-frame periods SF2 to SF5, which is the driving period of the sub-pixels, may further include an initialization period P1 (e.g., refer to FIG. 10) and a threshold voltage detection period P2 (e.g., refer to FIG. 10). For example, the second sub-frame period SF2 may include an initialization period P1, a threshold voltage detection period P2, a data writing period P3, and an emission period P4. The first emission control signal EM1 may be additionally maintained at an active level in the initialization period P1 of the second sub-frame period SF2 and the threshold voltage detection period P2 of the second sub-frame period SF2. The second emission control signal EM2 may be additionally maintained at an active level in the initialization period P1 of the second sub-frame period SF2 and the threshold voltage detection period P2 of the second sub-frame period SF2. The third emission control signal EM3 may be additionally maintained at an active level in the initialization period P1 of the second sub-frame period SF2 and the threshold voltage detection period P2 of the second sub-frame period SF2. The fourth emission control signal EM4 may be additionally maintained at an active level in the initialization period P1 of the second sub-frame period SF2 and the threshold voltage detection period P2 of the second sub-frame period SF2. The fifth emission control signal EM5 may be additionally maintained at an active level in the initialization period P1 of the second sub-frame period SF2 and the threshold voltage detection period P2 of the second sub-frame period SF2.

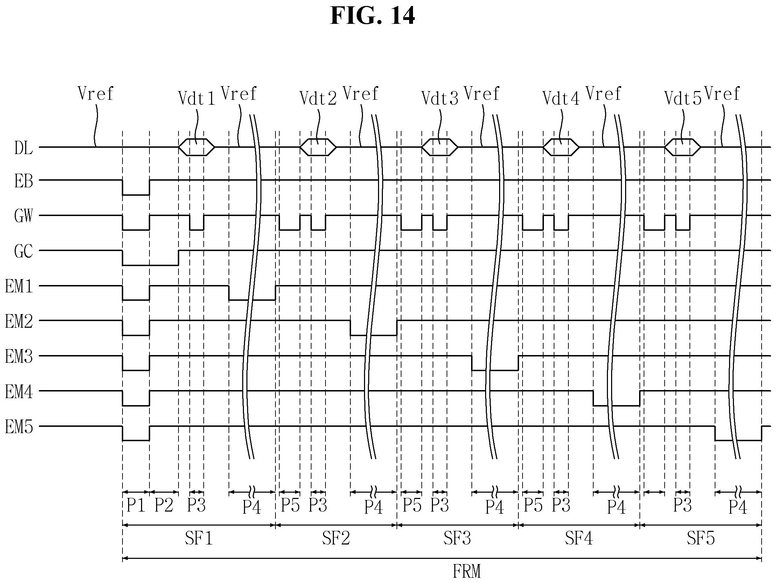

FIG. 14 is a schematic diagram illustrating an embodiment in respect to a timing diagram of a reference voltage Vref, data voltages Vdt1, a bias scan signal EB, a write scan signal GW, a compensation scan signal GC, a first emission control signal EM1, a second emission control signal EM2, a third emission control signal EM3, a fourth emission control signal EM4, and a fifth emission control signal EM5 of FIG. 12.

The timing diagram of FIG. 14 is different from the timing diagram of FIG. 13 at least in that each of the remaining sub-frame periods FRM except the first sub-frame period SF1 further includes a reset period P5. Thus, detailed description of the same or similar constituent elements is omitted.

As illustrated in FIG. 14, the second sub-frame period SF2 may include a reset period P5, a data writing period P3, and an emission period P4. The reset period P5 of the second sub-frame period SF2 may be disposed (or located) between the emission period P4 of the first sub-frame period SF1 and the data writing period P3 of the second sub-frame period SF2.

As illustrated in FIG. 14, the third sub-frame period SF3 may include reset period P5, a data writing period P3, and an emission period P4. The reset period P5 of the third sub-frame period SF3 may be disposed (or located) between the emission period P4 of the second sub-frame period SF2 and the data writing period P3 of the third sub-frame period SF3.

As illustrated in FIG. 14, the fourth sub-frame period SF4 may include reset period P5, a data writing period P3, and an emission period P4. The reset period P5 of the fourth sub-frame period SF4 may be disposed (or located) between the emission period P4 of the third sub-frame period SF3 and the data writing period P3 of the fourth sub-frame period SF4.

As illustrated in FIG. 14, the fifth sub-frame period SF5 may include reset period P5, a data writing period P3, and an emission period P4. The reset period P5 of the fifth sub-frame period SF5 may be disposed (or located) between the emission period P4 of the fourth sub-frame period SF4 and the data writing period P3 of the fifth sub-frame period SF5.

As illustrated in FIG. 14, in the reset period P5, the write scan signal GW may have an active level, and each of the remaining signals except the write scan signal GW (e.g., bias scan signal EB, compensation scan signal GC, first emission control signal EM1, second emission control signal EM2, third emission control signal EM3, fourth emission control signal EM4, and fifth emission control signal EM5) may have a non-active level. In the reset period P5, the reference voltage Vref may be applied to the data line DL.

For example, in FIG. 14, detailed description of the timing of the write scan signal GW in each frame period FRM is provided below.

During each frame period FRM, the write scan signal GW may have an active level in each of the initialization period P1 of the first sub-frame period SF1, the data writing period P3 of the first sub-frame period SF1, the reset period P5 of other sub-frame periods (e.g., the second to fifth sub-frame periods SF2 to SF5), and the data writing period P3 of other sub-frame periods (e.g., the second to fifth sub-frame periods SF2 to SF5). The other sub-frame periods may mean, for example, the remaining sub-frame periods (e.g., second to fifth sub-frame periods SF2 to SF5) except the first sub-frame period SF1.

The display device 10 (e.g., refer to FIG. 1) including the first to fifth pixels PX1 to PX5 of FIG. 12 described above may operate based on the timing diagram of FIG. 14. For example, in the reset period P5 of the second sub-frame period SF2, the write scan signal GW may have an active level, and the switching transistor Ts may be turned on in the reset period P5. In the reset period P5, the reference voltage Vref of the data line DL may be applied to the first electrode of the first capacitor C1 through the turned-on switching transistor Ts. The voltage of the first node N1 may be initialized (or reset) by a coupling operation of the first capacitor C1. Accordingly, the voltage can be prevented from accumulating at the first node N1, and the corresponding data voltage Vdt1 may be applied to the first node N1 at a normal value during the data writing period P3.

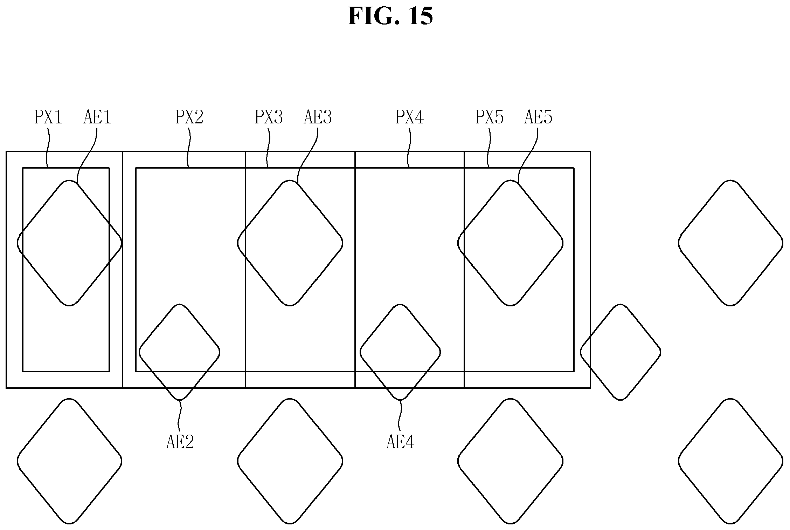

FIG. 15 is a schematic plan view of a display device according to an embodiment.

As illustrated in FIG. 15, the display device 10 may include a first pixel PX1, a second pixel PX2, a third pixel PX3, a fourth pixel PX4, and a fifth pixel PX5.

The first pixel PX1 may include a first anode electrode AE1. The first anode electrode AE1 may be the anode electrode of the first light emitting element LE1 (e.g., refer to FIG. 12).

The second pixel PX2 may include a second anode electrode AE2. The second anode electrode AE2 may be the anode electrode of the second light emitting element LE2 (e.g., refer to FIG. 12).

The third pixel PX3 may include a third anode electrode AE3. The third anode electrode AE3 may be the anode electrode of the third light emitting element LE3 (e.g., refer to FIG. 12).

The fourth pixel PX4 may include a fourth anode electrode AE4. The fourth anode electrode AE4 may be the anode electrode of the fourth light emitting element LE4 (e.g., refer to FIG. 12).

The fifth pixel PX5 may include a fifth anode electrode AE5. The fifth anode electrode AE5 may be the anode electrode of the fifth light emitting element LE5 (e.g., refer to FIG. 12).

Driving circuits of the display device 10 (e.g., refer to FIG. 1) may be disposed in the above-described idle area. For example, at least one of the power supply circuit 500, the scan driver 610, the light emission driver 620, and the data driver 700 of FIG. 2 may be divided and disposed in each idle area of the second pixel PX2, the third pixel PX3, and the fourth pixel PX4, and the fifth pixel PX5.

The first anode electrode AE1 may overlap at least one of the configurations of the pixel circuit PC (e.g., refer to FIG. 11) in a plan view, and at least one of the second to fifth anode electrodes AE2 to AE5 may overlap at least some of the driving circuit of the display device 10 described above in a plan view.

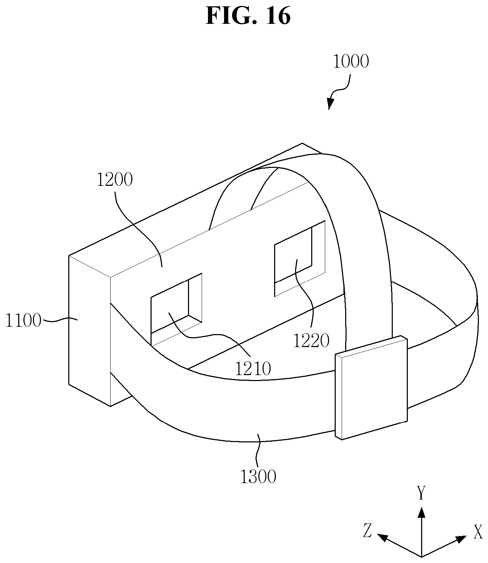

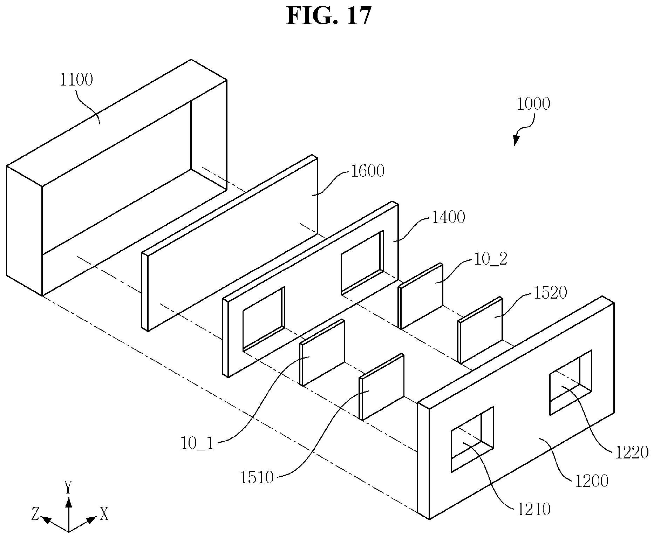

FIG. 16 is a schematic perspective view illustrating a head mounted display device according to an embodiment. FIG. 17 is a schematic exploded perspective view illustrating an example of the head mounted display device of FIG. 16.

Referring to FIGS. 16 and 17, a head mounted display 1000 according to an embodiment may include a first display device 10_1, a second display device 10_2, a display device housing 1100, a housing cover 1200, a first eyepiece 1210, a second eyepiece 1220, a head mounted band 1300, a middle frame 1400, a first optical member 1510, a second optical member 1520, and a control circuit board 1600.

The first display device 10_1 may provide an image to the user's left eye, and the second display device 10_2 may provide an image to the user's right eye. Since each of the first display device 10_1 and the second display device 10_2 is substantially the same as or similar to the display device 10 described in conjunction with FIGS. 1 to 15, detailed description of the first display device 10_1 and the second display device 10_2 is omitted.

The first optical member 1510 may be disposed between the first display device 10_1 and the first eyepiece 1210. The second optical member 1520 may be disposed between the second display device 10_2 and the second eyepiece 1220. Each of the first optical member 1510 and the second optical member 1520 may include at least one convex lens.

The middle frame 1400 may be disposed between the first display device 10_1 and the control circuit board 1600 and between the second display device 10_2 and the control circuit board 1600. The middle frame 1400 may support and fix the first display device 10_1, the second display device 10_2, and the control circuit board 1600.

The control circuit board 1600 may be disposed between the middle frame 1400 and the display device housing 1100. The control circuit board 1600 may be electrically connected to the first display device 10_1 and the second display device 10_2 through the connector. The control circuit board 1600 may convert an image source inputted from the outside into digital video data DATA (e.g., refer to FIG. 2), and transmit the digital video data DATA to the first display device 10_1 and the second display device 10_2 through the connector.

The control circuit board 1600 may transmit the digital video data DATA corresponding to a left-eye image optimized for the user's left eye to the first display device 10_1, and may transmit the digital video data DATA corresponding to a right-eye image optimized for the user's right eye to the second display device 10_2. In other embodiments, the control circuit board 1600 may transmit the same or similar to digital video data DATA to the first display device 10_1 and the second display device 10_2.

The display device housing 1100 may accommodate the first display device 10_1, the second display device 10_2, the middle frame 1400, the first optical member 1510, the second optical member 1520, and the control circuit board 1600. The housing cover 1200 may cover an open surface of the display device housing 1100. The housing cover 1200 may include the first eyepiece 1210 at which the user's left eye is disposed and the second eyepiece 1220 at which the user's right eye is disposed. FIGS. 16 and 17 illustrate the first eyepiece 1210 and the second eyepiece 1220 disposed separately, but embodiments of the specification are not limited thereto. The first eyepiece 1210 and the second eyepiece 1220 may be combined into one (or be integral with each other).

The first eyepiece 1210 may be aligned with the first display device 10_1 and the first optical member 1510, and the second eyepiece 1220 may be aligned with the second display device 10_2 and the second optical member 1520. Therefore, the user may view, through the first eyepiece 1210, the image of the first display device 10_1 magnified as a virtual image by the first optical member 1510, and may view, through the second eyepiece 1220, the image of the second display device 10_2 magnified as a virtual image by the second optical member 1520.

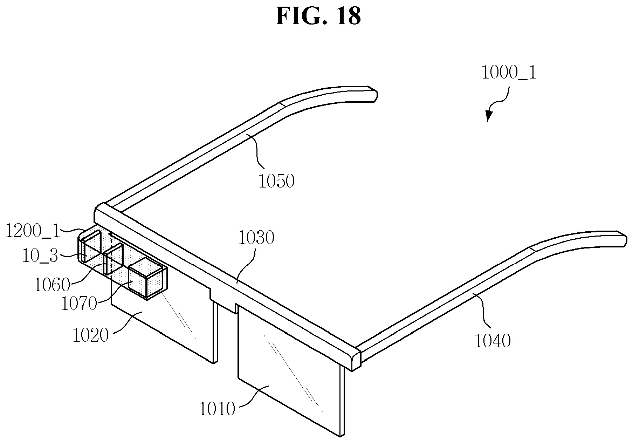

The head mounted band 1300 may secure the display device housing 1100 to the user's head, and the first eyepiece 1210 and the second eyepiece 1220 of the housing cover 1200 may remain disposed on the user's left and right eyes, respectively. In case that the display device housing 1100 is lightweight and compact, the head mounted display 1000 may be provided with, as shown in FIG. 18, an eyeglass frame instead of the head mounted band 1300.

The head mounted display 1000 may further include a battery for supplying power, an external memory slot for accommodating an external memory, an external connection port, a wireless communication module for receiving an image source, or the like. The external connection port may be a universe serial bus (USB) terminal, a display port, a high-definition multimedia interface (HDMI) terminal, or the like. The wireless communication module may be a 5G communication module, a 4G communication module, a Wi-Fi module, a Bluetooth module, or the like.

FIG. 18 is a schematic perspective view illustrating a head mounted display device according to an embodiment.

Referring to FIG. 18, a head mounted display 1000_1 according to an embodiment may be an eyeglasses-type display device in which a display device housing 1200_1 has a lightweight and compact manner. The head mounted display 1000_1 according to an embodiment may include a display device 10_3, a left eye lens 1010, a right eye lens 1020, a support frame 1030, temples 1040 and 1050, an optical member 1060, an optical path changing member 1070, and the display device housing 1200_1.

The display device housing 1200_1 may include the display device 10_3, the optical member 1060, and the optical path changing member 1070. The image displayed on the display device 10_3 may be magnified by the optical member 1060, and may be provided to the user's right eye through the right eye lens 1020 after the optical path of the head mounted display 1000_1 is changed by the optical path changing member 1070. As a result, the user may view an augmented reality image through the right eye, in which a virtual image displayed on the display device 10_3 and a real image seen through the right eye lens 1020 are combined.

FIG. 18 illustrates the display device housing 1200_1 disposed at the right end of the support frame 1030, but embodiments of the specification are not limited thereto. For example, the display device housing 1200_1 may be disposed at the left end of the support frame 1030, and the image of the display device 10_3 may be provided to the user's left eye. In other embodiments, the display device housing 1200_1 may be disposed on any one of the left and right ends of the support frame 1030, and the user may view the image displayed on the display device 10_3 through the left and right eyes.

The display device according to the embodiment can be applied to various electronic devices. The electronic device according to one embodiment includes the display device described above and may further include modules or devices having additional functions in addition to the display device.

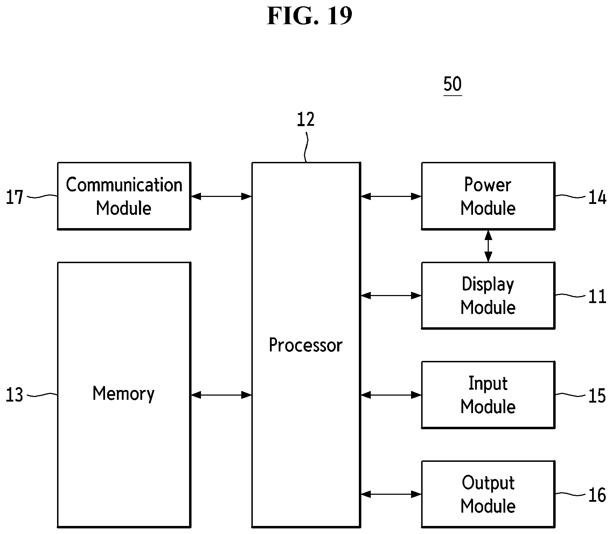

FIG. 19 is a block diagram of an electronic device according to one embodiment. Referring to FIG. 19, the electronic device 50 according to one embodiment may include a display module, a processor 12, a memory 13, and a power module 14. The electronic device 5000 may further include an input module 14, a non-image output module 15 and/or a communication module 16.

The electronic device 50 may output various information in the form of images through the display module 11. When the processor 12 executes an application stored in the memory 13, image information provided by the application may be provided to the user through the display module 1100. The power module 14 may include a power supply module such as a power adapter or a battery device, and a power conversion module that converts the power supplied by the power supply module to generate power required for the operation of the electronic device 5000. The input module 14 may provide input information to the processor 12 and/or the display module 11. The non-image output module 15 may receive information other than images transmitted from the processor 12, such as sound, haptics, and light, and provide the information to the user. The communication module 16 is a module that is responsible for transmitting and receiving information between the electronic device 5000 and an external device, and may include a receiving unit and a transmitting unit.

At least one of the components of the electronic device 50 described above may be included in the display device according to the embodiments described above. In addition, some of the individual modules functionally included in one module may be included in the display device, and others may be provided separately from the display device. For example, the display device includes a display module 11, and the processor 12, memory 13, and power module 14 may be provided in the form of other devices within the electronic device 11 other than the display device.

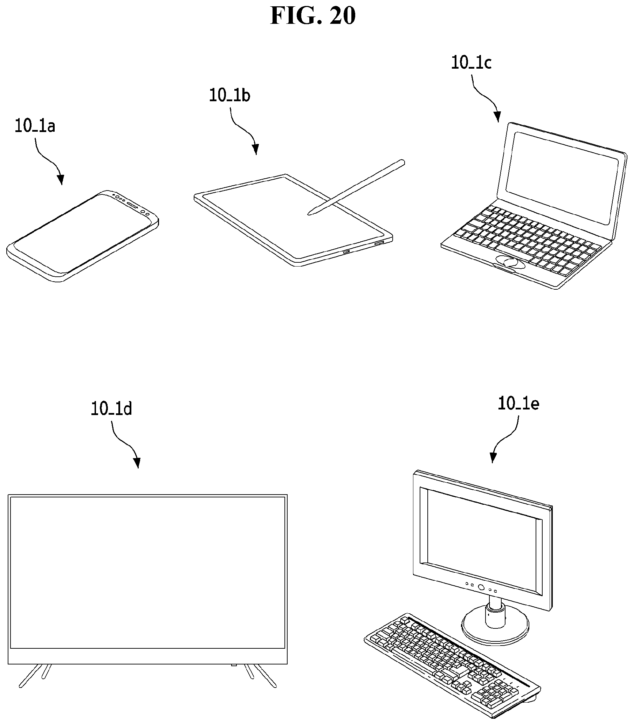

FIGS. 20, 21, and 22 are schematic diagrams of electronic devices according to various embodiments. FIGS. 20 to 22 illustrate examples of various electronic devices to which the display device according to the embodiments is applied.

FIG. 20 illustrates a smartphone 10_1a, a tablet PC 10_1b, a laptop 10_1c, a TV 10_1d, and a desk monitor 10_1e as examples of electronic devices.

In addition to the display module 11, the smartphone 10_1a may include an input module such as a touch sensor and a communication module. The smartphone 10_1a may process information received through the communication module or other input modules and display the information through the display module of the display device.

In the case of tablet PCs 10_1b, laptops 10_1c, TVs 10_1d, and desk monitors 10_1e, they also include display modules and input modules similar to smartphones 10_1, and may additionally include communication modules in some cases.

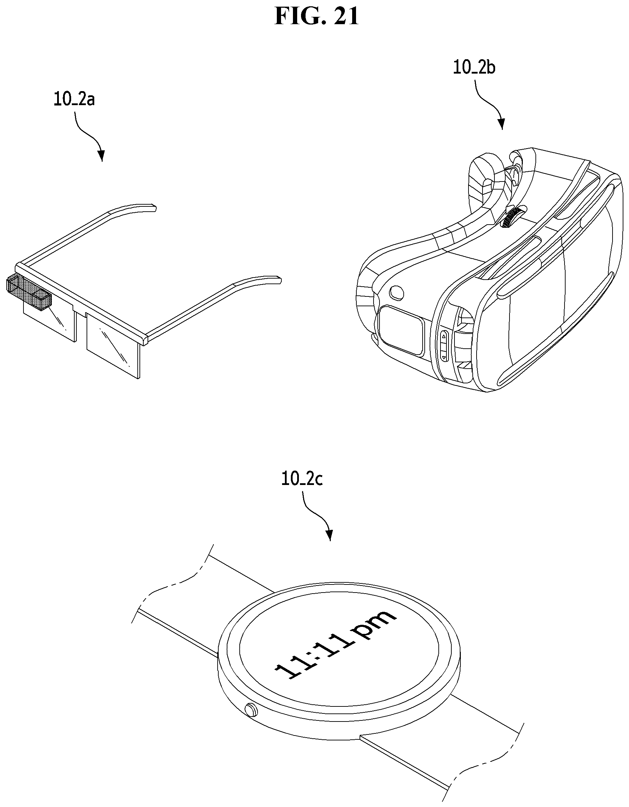

Fig. 21 shows an example of an electronic device including a display module being applied to a wearable electronic device. The wearable electronic device may be a smart glasses 10_2a, a head-mounted display 10_2b, a smart watch 10_2c, etc.

The smart glasses 10_2a and the head-mounted display 10_2b may include a display module that emits a display image and a reflector that reflects the emitted display screen and provides it to the user's eyes, thereby providing a virtual reality or augmented reality screen to the user.

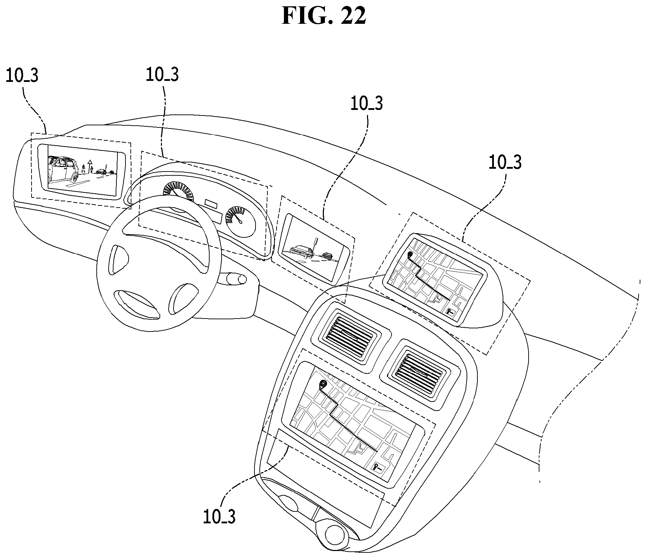

The smart watch 10_2c includes a biometric sensor as an input device, and may provide biometric information recognized by the biometric sensor to the user through the display module. Fig. 22 illustrates a case where an electronic device including a display module is applied to a vehicle. For example, the electronic device 10_3 may be applied to a dashboard, center fascia, etc. of a vehicle, or may be applied to a CID (Center Information Display) placed on a dashboard of a vehicle, or a room mirror display replacing a side mirror.

As discussed, embodiments may provide a display device comprising: a first pixel comprising: a switching transistor connected to a data line; a driving transistor connected to the switching transistor; a first emission control transistor connected to the driving transistor; and a first light emitting element connected to the first emission control transistor; a second pixel comprising: a second emission control transistor connected to a contact point between the driving transistor and the first emission control transistor; and a second light emitting element connected to the second emission control transistor; and a data driver arranged to transmit a reference voltage, a first data voltage of the first pixel, and a second data voltage of the second pixel to the data line, wherein the first light emitting element is arranged to emit light during a first sub-frame period of a frame period, the second light emitting element is arranged to emit light during a second sub-frame period of the frame period, and a gate electrode of the driving transistor is arranged to be initialized by the reference voltage from the data line during the first sub-frame period.

Embodiments may provide an optical device comprising: a display device; and an optical path conversion member on the display device, wherein the display device is according to any of the above described embodiments.

Embodiments may provide an electronic device comprising: a display device including a screen, wherein the display device is according to any of the above described embodiments.

The above description is an example of technical features of the disclosure, and those skilled in the art to which the disclosure pertains will be able to make various modifications and variations. Thus, the embodiments of the disclosure described above may be implemented separately or in combination with each other.

Therefore, the embodiments disclosed in the disclosure are not intended to limit the the disclosure, but to describe the disclosure, and the scope of the disclosure is not limited by these embodiments. The protection scope of the disclosure should be interpreted by the following claims, and it should be interpreted that all technical implementations within the equivalent scope are included in the scope of the disclosure.

## Claims

1. A display device comprising:
a first pixel comprising:
a switching transistor connected to a data line;
a driving transistor connected to the switching transistor;
a first emission control transistor connected to the driving transistor; and
a first light emitting element connected to the first emission control transistor;
a second pixel comprising:
a second emission control transistor connected to a contact point between the driving transistor and the first emission control transistor; and
a second light emitting element connected to the second emission control transistor; and
a data driver arranged to transmit a reference voltage, a first data voltage of the first pixel, and a second data voltage of the second pixel to the data line,
wherein
the first light emitting element is arranged to emit light during a first sub-frame period of a frame period,
the second light emitting element is arranged to emit light during a second sub-frame period of the frame period, and
a gate electrode of the driving transistor is arranged to be initialized by the reference voltage from the data line during the first sub-frame period.

2. The display device of claim 1, wherein the gate electrode of the driving transistor is initialized by the reference voltage from the data line during the second sub-frame period.

3. The display device of claim 1 or 2, wherein the first pixel further comprises an initialization transistor connected between the contact point and a ground or between the contact point and an initialization voltage line.

4. The display device of claim 3, wherein the first pixel further comprises a common emission control transistor connected between a driving voltage line and the driving transistor.

5. The display device of claim 4, wherein the first pixel further comprises:
a first capacitor connected between the gate electrode of the driving transistor and a source electrode of the driving transistor; and
a second capacitor connected between the source electrode of the driving transistor and the driving voltage line;
optionally further comprising: a write scan line connected to a gate electrode of the switching transistor and transmitting a write scan signal; a common emission control line connected to a gate electrode of the common emission control transistor and transmitting a common emission control signal; a first emission control line connected to a gate electrode of the first emission control transistor and transmitting a first emission control signal; a second emission control line connected to a gate electrode of the second emission control transistor and transmitting a second emission control signal; and a bias scan line connected to a gate electrode of the initialization transistor and transmitting a bias scan signal;
further optionally wherein the bias scan signal has an active level in an initialization period of the first sub-frame period and an initialization period of the second sub-frame period, the write scan signal has an active level in the initialization period of the first sub-frame period, a data writing period of the first sub-frame period, the initialization period of the second sub-frame period, and a data writing period of the second sub-frame period, the common emission control signal has an active level in the initialization period of the first sub-frame period, an emission period of the first sub-frame period, the initialization period of the second sub-frame period, and an emission period of the second sub-frame period, the first emission control signal has an active level in the initialization period of the first sub-frame period and the emission period of the first sub-frame period, and the second emission control signal has an active level in the initialization period of the second sub-frame period and the emission period of the second sub-frame period;
still further optionally wherein the reference voltage is applied to the data line during the initialization period of the first sub-frame period, a threshold voltage detection period of the first sub-frame period, the emission period of the first sub-frame period, the initialization period of the second sub-frame period, a threshold voltage detection period of the second sub-frame period, and the emission period of the second sub-frame period, the first data voltage is applied to the data line during a data writing period of the first sub-frame period, and the second data voltage is applied to the data line during a data writing period of the second sub-frame period.

6. The display device of any one of claims 3 to 5, wherein the first pixel further comprises a compensation transistor connected between the gate electrode of the driving transistor and the contact point;
optionally wherein the first pixel further comprises: a first capacitor connected between the switching transistor and the gate electrode of the driving transistor; and a second capacitor connected between the gate electrode of the driving transistor and a driving voltage line;
optionally wherein the driving transistor is connected between the driving voltage line and the contact point.

7. The display device of claim 6, further comprising:
a write scan line connected to a gate electrode of the switching transistor and transmitting a write scan signal;
a compensation scan line connected to a gate electrode of the compensation transistor and transmitting a compensation scan signal;
a first emission control line connected to a gate electrode of the first emission control transistor and transmitting a first emission control signal;
a second emission control line connected to a gate electrode of the second emission control transistor and transmitting a second emission control signal; and
a bias scan line connected to a gate electrode of the initialization transistor and transmitting a bias scan signal;
optionally:
wherein the bias scan signal has an active level during an initialization period of the first sub-frame period, the write scan signal has an active level in the initialization period of the first sub-frame period, a data writing period of the first sub-frame period, and a data writing period of the second sub-frame period, the compensation scan signal has an active level in the initialization period of the first sub-frame period and a threshold voltage detection period of the first sub-frame period, the first emission control signal has an active level in the initialization period of the first sub-frame period and an emission period of the first sub-frame period, and the second emission control signal has an active level in the initialization period of the second sub-frame period and an emission period of the second sub-frame period; or
wherein the bias scan signal has an active level during an initialization period of the first sub-frame period, a write scan signal has an active level in the initialization period of the first sub-frame period, a data writing period of the first sub-frame period, a reset period of the second sub-frame period, and a data writing period of the second sub-frame period, the compensation scan signal has an active level in the initialization period of the first sub-frame period and a threshold voltage detection period of the first sub-frame period, the first emission control signal has an active level in the initialization period of the first sub-frame period and an emission period of the first sub-frame period, and the second emission control signal has an active level in the initialization period of the first sub-frame period and an emission period of the second sub-frame period.

8. The display device of any one of claims 1 to 7, further comprising:
a third pixel comprising:
a third emission control transistor; and
a third light emitting element connected to the third emission control transistor;
optionally wherein the data driver is further arranged to apply a third data voltage of the third pixel to the data line, the third light emitting element is arranged to emit light during a third sub-frame period of the frame period, and the gate electrode of the driving transistor is arranged to be initialized by a reference voltage from the data line during the third sub-frame period.

9. The display device of claim 8, further comprising:
a fourth pixel comprising:
a fourth emission control transistor; and
a fourth light emitting element connected to the fourth emission control transistor.

10. The display device of claim 9, wherein
the data driver is further arranged to apply a fourth data voltage of the fourth pixel to the data line,
the fourth light emitting element is arranged to emit light during a fourth sub-frame period of the frame period, and
the gate electrode of the driving transistor is arranged to be initialized by a reference voltage from the data line during the fourth sub-frame period.

11. The display device of claim 9 or 10, further comprising:
a fifth pixel comprising:
a fifth emission control transistor; and
a fifth light emitting element connected to the fifth emission control
transistor;
optionally wherein the data driver is further arranged to apply a fifth data voltage of the fifth pixel to the data line, the fifth light emitting element is arranged to emit light during a fifth sub-frame period of the frame period, and the gate electrode of the driving transistor is arranged to be initialized by a reference voltage from the data line during the fifth sub-frame period.

12. The display device of any one of claims 1 to 11, further comprising:
a driving circuit overlapping the second pixel in a plan view;
optionally wherein the driving circuit comprises at least one of: a power supply circuit arranged to provide a driving voltage to the driving transistor; a scan driver arranged to provide a scan signal to a gate electrode of the switching transistor; an emission driver arranged to provide an emission control signal to each of a gate electrode of the first emission control transistor and a gate electrode of the second emission control transistor; and the data driver.

13. An optical device comprising:
a display device; and
an optical path conversion member on the display device, wherein
the display device is according to any one of claims 1 to 12.

14. The optical device of claim 13, wherein the optical device is at least one of a smart watch, a mobile phone, a smartphone, a portable computer, a tablet personal computer (PC), a watch phone, an automotive display, a smart glass, a portable multimedia player (PMP), a navigation system, an ultra mobile computer (UMPC), a head mounted display (HMD) device, a virtual reality (VR) device, a mixed reality (MR) device, and an augmented reality (AR) device.

15. An electronic device comprising:
a display device including a screen,
wherein the display device is according to any one of claims 1 to 12.
